(19) Europäisches Patentamt
European Patent Office
Office européen des brevets

(11) **EP 3 410 589 B1**

(12) **EUROPÄISCHE PATENTSCHRIFT**

(45) Veröffentlichungstag und Bekanntmachung des Hinweises auf die Patenterteilung:
**11.09.2019 Patentblatt 2019/37**

(51) Int Cl.:
**H02M 1/08** *(2006.01)*  **H02M 1/12** *(2006.01)*
**H03K 17/16** *(2006.01)*  **H02M 1/00** *(2006.01)*

(21) Anmeldenummer: **17173317.3**

(22) Anmeldetag: **29.05.2017**

(54) **UMRICHTER, VORRICHTUNG MIT EINEM SOLCHEN UMRICHTER, SYSTEM UND VERFAHREN ZUM STEUERN EINER STEUERBAREN ENERGIEQUELLE**

INVERTER, DEVICE WITH SUCH AN INVERTER, SYSTEM AND METHOD FOR CONTROLLING A CONTROLLABLE ENERGY SOURCE

INVERSEUR, DISPOSITIF AVEC UN TEL INVERSEUR, SYSTÈME ET PROCÉDÉ DE COMMANDE D'UNE SOURCE D'ÉNERGIE CONTRÔLABLE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**05.12.2018 Patentblatt 2018/49**

(73) Patentinhaber: **Fraunhofer-Gesellschaft zur Förderung der angewandten Forschung e.V.
80686 München (DE)**

(72) Erfinder:
• **MATLOK, Stefan
91058 Erlangen (DE)**

• **ECKARDT, Bernd
90475 Nürnberg (DE)**

(74) Vertreter: **Burger, Markus et al
Schoppe, Zimmermann, Stöckeler
Zinkler, Schenk & Partner mbB
Patentanwälte
Radlkoferstraße 2
81373 München (DE)**

(56) Entgegenhaltungen:
DE-A1-102011 003 733    JP-A- H04 340 391
US-A- 4 706 180          US-A1- 2008 316 780
US-A1- 2016 172 975      US-A1- 2016 285 380

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

## Beschreibung

Die vorliegende Erfindung bezieht sich auf einen Umrichter, etwa zum Ansteuern einer elektrischen Last, auf eine Vorrichtung mit einem derartigen Umrichter und auf ein System mit einer derartigen Vorrichtung. Die vorliegende Erfindung bezieht sich ferner auf ein Verfahren zum Steuern einer steuerbaren Energiequelle. Die vorliegende Erfindung bezieht sich ferner auf ein Doppelpulsfilter.

Eine elektrische Last, etwa ein Motor oder dergleichen kann mit einer elektrischen Ansteuerung angesteuert werden. Dies kann mit getakteten Signalen wie etwa pulsweitenmodulierten (PWM)-Signalen erfolgen. Für eine veränderliche Ansteuerung unter Ausnutzung von PWM-Signalen kann ein Umrichter verwendet werden, der das PWM-Signal mit einem veränderlichen Tastgrad oder Einschaltdauer (duty cycle) ausgibt. Bekannte Umrichter takten mit einer Frequenz von typischerweise 1 kHz bis 10 kHz. Eine Anforderung hierbei ist, dass Schaltflanken von Halbbrückenmodulen sehr langsam sein sollen (wegen EMV, Spannungsüberhöhung bei langen Leitungen, Lebensdauer Isolationsmaterialien), das heißt eine geringe Flankensteilheit aufweisen, die in einem Bereich von ca. 0,5 kV/µs bis in etwa 10 kV/µs liegt. Um dies zu erreichen, wird ein Abbremsen oder ein Verschleifen der Schaltflanken durch entsprechend langsame Schaltvorgänge genutzt. Allerdings verursachen derartige Schaltvorgänge hohe Schaltverluste, die die Systemeffizienz verringern und nachteilig sind. Dies führt dazu, dass neue und schnellschaltende Bauelemente wie SiC- oder GaN-Bauelemente nicht sinnvoll genutzt werden können, da diese in derartigen Anwendungen künstlich und massiv gebremst werden.

Zur Lösung dieser Nachteile existieren Lösungsansätze, in denen ein sogenanntes Sinusfilter eingesetzt wird. Dieses Filter glättet den Stromverlauf über die gesamte Sinusperiode hinweg. Am Ausgang des Wandlers wird eine Sinusspannung erzeugt. Der erhaltene Vorteil liegt darin, dass das Schaltmodul nun beliebig schalten kann, da das Sinusfilter die hohen Schaltflanken (du/dt) verträgt. Allerdings weist dieses Konzept den Nachteil auf, dass das Sinusfilter einen hohen Bauraumbedarf und/oder ein hohes Gewicht mit sich bringt. Um das Filter nicht übermäßig groß zu gestalten, wird die Schaltfrequenz des Moduls erhöht, das bedeutet, das Modul wird mit einer höheren Schaltfrequenz betrieben. Dies führt jedoch zu einer Erhöhung von Schaltverlusten in dem ungeachtet dessen immer noch relativ bezogen auf Bauraum und Gewicht großen Sinusfilters.

Einen weiteren Lösungsansatz bilden du/dt Filter, welche durch passive Elemente die Schaltflankensteilheit reduzieren. Diese weißen auch immer ein ohmsches Element auf, an dem ein Teil der in diesem Filter gespeicherten Energie thermisch umgesetzt wird. Dies erfordert einen entsprechend hohen Kühlaufwand und reduziert den Wirkungsgrad des Systems.

In US 2008/0316780 A1 ist ein Verfahren und eine Anordnung beschrieben, um die Ausgangsspannungspulse eines PWM-Frequenzkonverters zu steuern, wobei der PWM-Frequenzkonverter eine Netzwerkbrücke ist. Die Pulsbreiten der Pulse so gesteuert, dass sie im Fall eines einzelnen Pulses so ausgestaltet werden, dass die Ausgangsspannung während des Pulses auf über 50% der Spannung im Endzustand ansteigt.

In JP H04-340391 ist ein Verfahren zur Motorsteuerung beschrieben, insbesondere eines bürstenlosen Motors. Mikropulse weisen eine kleine zeitliche Breite auf.

Wünschenswert wäre demnach ein Umrichter, eine Vorrichtung mit einem derartigen Umrichter und ein System mit einer zuvor genannten Vorrichtung sowie ein Verfahren, das eine effiziente Ansteuerung einer elektrischen Last mit geringen Schaltverlusten und unter Verwendung kleiner und weitgehend verlustfreier Filter ermöglicht.

Eine Aufgabe der vorliegenden Erfindung besteht deshalb darin, ein Konzept zu schaffen, das eine Ansteuerung einer elektrischen Last mit geringen Schaltungsverlusten ermöglicht und gleichzeitig mit geringem Bauraumbedarf und/oder mit geringem Gewicht realisierbar ist.

Diese Aufgabe wird durch den Gegenstand der unabhängigen Patentansprüche gelöst.

Eine Erkenntnis der vorliegenden Erfindung besteht darin, erkannt zu haben, dass die Schwingungen eines Filters, die bei Erreichen einer Resonanzfrequenz desselben erhalten werden und nachteilhaft sind, vermieden werden können, indem vor einen PWM-Flankenwechsel ein Impuls ausgegeben wird, der eine Kompensation des Resonanzschwingens ermöglicht, so dass sowohl hohe Schaltfrequenzen als auch kleine und leichte elektrische Bauteile verwendet werden können. Damit können geringe elektrische Verluste und weitgehend verlustfreie Filter erhalten werden.

Gemäß einem Ausführungsbeispiel umfasst ein Umrichter eine steuerbare Energiequelle, die ausgebildet ist, um eine elektrische Größe auszugeben, und eine Steuereinheit, die ausgebildet ist, um die steuerbare Energiequelle zu steuern, so dass die steuerbare Energiequelle die elektrische Größe so ausgibt, dass vor einer ersten Flanke, die in einem Verlauf der elektrischen Größe einen Wechsel zwischen einem ersten Pegel und einem zweiten Pegel beschreibt, ein Impuls ausgeben wird, der eine zweite und eine dritte Flanke des Verlaufs aufweist. Dies ermöglicht eine Vorab-Anregung des Filters, die durch die nachfolgende PWM-Flanke wieder kompensiert wird.

Gemäß einem weiteren Ausführungsbeispiel ist die Steuereinheit ausgebildet, um die Energiequelle so zu steuern, dass diese mit einem eine Taktperiodendauer aufweisenden Takt wiederholende Wechsel zwischen dem ersten und dem zweiten Pegel ausgibt, und so dass diese den Impuls mit einem zeitlichen Abstand von der ersten Flanke von höchstens 25 % der Taktperiodendauer ausgibt und/oder wobei der der ersten Flanke vorangehende Impuls eine Dauer aufweist, die höchstens 25 % der Taktperiodendauer beträgt. Dies ermöglicht eine Ausgestaltung des Impulses derart, dass die Schwingungen in dem Filter in einem hohen Maß kompensiert werden.

Gemäß einem weiteren Ausführungsbeispiel ist die Steuereinheit ausgebildet, um die Energiequelle so zu steuern, dass eine zeitliche Dauer des Impulses mit einer Toleranz von $\pm 20$ % gleich dem zeitlichen Abstand zwischen dem Impuls und der ersten Flanke ist. Dies ermöglicht eine präzise phasenmäßige Korrelation von durch den Impuls ausgelösten Schwingungen in dem Filter und durch die Flanke gegenphasig angeregten Schwingungen in dem Filter.

Gemäß einem Ausführungsbeispiel ist der Impuls ein erster Impuls und die Steuereinheit ausgebildet, um die steuerbare Energiequelle so zu steuern dass diese die elektrische Größe so ausgibt, dass vor einer vierten Flanke, die in dem Verlauf der elektrischen Grüße einen Wechsel zwischen dem zweiten Pegel und einem dritten Pegel beschreibt, ein zweiter Impuls ausgeben wird, der eine fünfte und eine sechste Flanke des Verlaufs aufweist. Dies ermöglicht die Schwingungskompensation in weiteren Flankenwechseln.

Gemäß einem weiteren Ausführungsbeispiel ist die Steuervorrichtung ausgebildet, um die steuerbare Energiequelle so zu steuern, dass diese mit einem eine Taktperiodendauer aufweisenden Takt wiederholende Wechsel zwischen dem ersten und dem zweiten Pegel ausgibt, und so dass der ersten Flanke eine Folge von zumindest zwei Impulsen vorausgeht, wobei eine zeitliche Dauer der Folge der zumindest zwei Impulse höchstens 25 % der Taktperiodendauer beträgt. Dies ermöglicht eine zusätzliche Anregung von Schwingungen oder Gegenschwingungen, so dass eine effiziente Schwingungskompensation durch mehrere Komponenten ermöglicht ist.

Gemäß einem Ausführungsbeispiel ist der Umrichter ausgebildet, um zumindest einen der ersten Flanke vorausgehenden Impuls so zu erzeugen, dass eine Filterantwort auf die erste Flanke und auf den Impuls sich so überlagern, dass Schwingungen in der Filterantwort zumindest teilweise kompensiert werden. Dies ermöglicht eine Glättung der Filterantwort auch bei ungedämpften oder schwingfähigen Filtern, die bspw. eine hohe Eigenfrequenz aufweisen.

Gemäß einem Ausführungsbeispiel umfasst eine Vorrichtung einen zuvor beschriebenen Umrichter und ein Filter. Die Steuereinheit ist ausgebildet, um die steuerbare Energiequelle so zu steuern, dass der Impuls einen zeitlichen Abstand zu der ersten Flanke aufweist, und dass eine Filterantwort des Filters auf den Impuls Schwingungen des Filters, die auf der ersten Flanke beruhen, zumindest teilweise kompensiert. Dies ermöglicht eine glatte Filterantwort zur störungsfreien und beschädigungsfreien Ansteuerung einer mit dem Filter verbindbaren Last.

Gemäß einem Ausführungsbeispiel ist das Filter ein Tiefpass, umfassend ein induktives Element und eine kapazitives Element, das bedeutet, ein LC-Filter.

Gemäß einem Ausführungsbeispiel ist die Steuereinheit ausgebildet, um die steuerbare Energiequelle so zu steuern, dass eine zeitliche Dauer des Impulses innerhalb eines Toleranzbereichs von $\pm 10$ % dem Kehrwert einer Grenzfrequenz des Filters multipliziert mit dem Faktor 6 entspricht. Dies ermöglicht, dass der Impuls eine zeitliche Länge aufweist, die eine Spannungszeitfläche des Impulses ermöglicht, die ein hohes Maß an Schwingungskompensation ermöglicht. Ferner ermöglicht dies eine erste Zeit-Spannungs-Fläche, welche den Filter derart anregt, dass dieser seinen Ausgang ansprechend auf den neuen Pegel umlädt. Zudem führt dies zu einer anschießenden zweiten Zeit-Spannungs-Fläche, welche den Filter wieder in einen stationären Zustand auf dem neuen Pegel führt und somit im hohen Maße eine Oszillation unterdrückt.

Gemäß einem Ausführungsbeispiel ist die Steuereinheit ausgebildet, um die steuerbare Energiequelle so zu steuern, dass ein durch ein induktive Element des Filters fließender Strom zu einem Beginn des Impulses mit einer Toleranz von $\pm 5$ % gleich einem durch das induktive Element des Filters fließendem Strom zum Zeitpunkt der ersten Flanke ist. Dies ermöglicht eine hohe Symmetrie der Schwingungskompensation.

Gemäß einem Ausführungsbeispiel ist das Filter ausgebildet, um basierend auf der elektrischen Größe eine gefilterte elektrische Größe auszugeben, die bei einem Wechsel von dem ersten Pegel in den zweiten Pegel eine Flanke mit einer zeitlichen Dauer aufweist, wobei die Steuereinrichtung ausgebildet ist, um die steuerbare Energiequelle so zu steuern, dass eine Zeitdauer des zumindest einen Impulses mit einer Toleranz von $\pm 10$ % der Hälfte der zeitlichen Dauer der Flanke aufweist. Die in etwa hälftige Dauer des Impulses ermöglicht eine Positionierung einer zur ersten Flanke des Impulses entgegengesetzt wirkenden zweiten Flanke des Impulses und mithin eine phasenmäßig präzise Positionierung der Gegenschwingungen.

Gemäß einem Ausführungsbeispiel ist die Steuereinrichtung ausgebildet, um die Grenzfrequenz des Filters zu bestimmen, und um einen zeitlichen Abstand zwischen dem Impuls und der ersten Flanke und/oder eine Zeitdauer des Impulses basierend auf der bestimmten Grenzfrequenz einzustellen. Dies ermöglicht eine Anpassung der Impulse, etwa bei einer variablen Konfiguration des Filters.

Gemäß einem Ausführungsbeispiel umfasst ein System eine zuvor beschriebene Vorrichtung und eine elektrische Last, die mit einem Ausgang des Filters verbunden ist und zumindest einen Teil eines Resonanzschwingkreises bildet. Der Umrichter der Vorrichtung ist ausgebildet, um die Last mit einem pulsweitenmodulierten Signal, das eine Taktfrequenz aufweist, anzusteuern. Eine Grenzfrequenz des Filters ist höher als die Taktfrequenz. Dies ermöglicht, dass das System auf eine Flanke anspricht, so dass eine Mittelung über mehrere Taktzyklen vermieden werden kann und das Filter leicht ausgeführt werden kann und gleichzeitig eine hohe Taktfrequenz genutzt werden kann.

Gemäß einem Ausführungsbeispiel ist das Filter benachbart zu der elektrischen Last und beabstandet von der Steuereinrichtung angeordnet. Dies ermöglicht, dass das Filter an der möglicherweise stationär betriebenen elektrischen Last angeordnet werden kann.

Gemäß einem Ausführungsbeispiel ist das Filter ein LC-Filter und weist ein induktives Element auf, das durch ein Kabel zwischen dem Filter und der elektrischen Last realisiert ist. Dies ermöglicht eine einfache Ausgestaltung des Filters, da das Kabel ganz oder teilweise als Induktivität des Filters genutzt werden kann. Ferner ermöglicht dies eine Anpassung der Filterinduktivität, etwa durch Verwendung eines anderen Kabels.

Gemäß einem Ausführungsbeispiel ist das Filter ausgebildet, um basierend auf der elektrischen Größe eine gefilterte elektrische Größe auszugeben, die bei einem Wechsel von dem ersten Pegel in den zweiten Pegel eine Flanke mit einer Flankensteilheit aufweist, und bei dem ein Kapazitätswert eines kapazitiven Elements des Filters so gewählt ist, dass basierend auf einem Induktivitätswert eines induktiven Elements des Filters eine Flankensteilheit der gefilterten elektrischen Größe von höchstens 10 kV/μs erhalten wird. Dies ermöglicht den Erhalt von hohen Flankensteilheiten und einer effizienten Ansteuerung.

Gemäß einem Ausführungsbeispiel ist die Grenzfrequenz des Filters von einem parasitären Kapazitätswert der elektrischen Last oder einer Verbindung derselben mit einer steuerbaren Energiequelle bestimmt. Dies ermöglicht die Implementierung des Filters durch parasitäre Elemente, etwa einer Kabelverbindung zwischen der elektrischen Last und dem Umrichter. Dies ermöglicht ferner eine platzsparende Implementierung des Filters unter Vermeidung weiterer Komponenten.

Gemäß einem Ausführungsbeispiel ist die Grenzfrequenz von der Verbindung zwischen der elektrischen Last und der steuerbaren Energiequelle bestimmt, wobei die Verbindung einen parasitären Induktivitätswert und einen parasitären Kapazitätswert aufweist. Die Steuereinheit ist ausgebildet, um die steuerbare Energiequelle so zu steuern, dass der parasitäre Schwingkreis basierend auf dem Impuls so angeregt wird, dass der parasitäre Schwingkreis vor dem Impuls und nach der ersten Flanke in einem stationären Zustand ist. Dies ermöglicht eine robuste und verlustarme Ansteuerung der elektrischen Last.

Gemäß einem Ausführungsbeispiel umfasst ein Verfahren ein Ausgeben einer elektrischen Größe mit einer steuerbaren Energiequelle und ein Steuern der steuerbaren Energiequelle, so dass die steuerbare Energiequelle die elektrische Größe so ausgibt, dass vor einer ersten Flanke, die in einem Verlauf der elektrischen Größe einen Wechsel zwischen einem ersten Pegel und einem zweiten Pegel beschreibt, ein Impuls ausgegeben wird, der eine zweite und eine dritte Flanke des Verlaufs aufweist.

Bevorzugte Ausführungsbeispiele der vorliegenden Erfindung werden nachfolgend Bezug nehmend auf die beiliegenden Zeichnungen erläutert. Es zeigen:

Fig. 1a ein schematisches Blockschaltbild eines Umrichters gemäß einem Ausführungsbeispiel;

Fig. 1b eine schematische Ansicht eines Verlaufs einer von einem Umrichter bereitstellbaren elektrischen Größe über die Zeit gemäß einem Ausführungsbeispiel;

Fig. 1c einen weiteren zeitlichen Verlauf der elektrischen Größe gemäß einem Ausführungsbeispiel bei dem ein Wechsel eine Pegels der elektrischen Größe von einem ersten zu einem zweiten Pegel und von dort aus zu einem dritten Pegel erfolgt;

Fig. 1d einen weiteren zeitlichen Verlauf der elektrischen Größe gemäß einem Ausführungsbeispiel bei dem vor einer PWM-Flanke zumindest zwei Impulse angeordnet sind;

Fig. 1e eine Überlagerung einer Filterantwort, die basierend auf dem Impuls in einem Filter erhalten werden kann und einer Filterantwort, die beispielsweise basierend auf der PWM-Flanke in dem Filter erhalten werden kann;

Fig. 1f eine schematische Darstellung zur Bereitstellung der Pulsflanken in Fig. 1e;

Fig. 2 ein schematisches Blockschaltbild einer Vorrichtung gemäß einem Ausführungsbeispiel;

Fig. 3 ein schematisches Diagramm, dass die von der steuerbaren Energiequelle gemäß einem Ausführungsbeispiel bereitgestellte elektrische Größe darstellt;

Fig. 4 ein schematisches Blockschaltbild einer Vorrichtung gemäß einem Ausführungsbeispiel, bei der eine Steuereinheit ausgebildet ist, um die Grenzfrequenz $f_G$ eines Filters zu bestimmen;

Fig. 5 ein schematisches Blockschaltbild eines Systems gemäß einem Ausführungsbeispiel;

Fig. 6 ein schematisches Blockschaltbild eines Systems gemäß einem Ausführungsbeispiel, das den Umrichter gemäß Fig. 1 umfasst, der mittels eines Kabels mit einer elektrischen Last verbunden ist;

Fig. 7a ein schematisches Blockschaltbild eines Systems gemäß einem Ausführungsbeispiel mit einem Umrichter, der als Halbbrücke ausgeführt ist, und der das Filter umfasst;

Fig. 7b    ein schematisches Blockschaltbild eines Systems 70 gemäß einem Ausführungsbeispiel, bei dem das Kabel ein induktives Element des Filters bildet;

Fig. 8    ein schematisches Flussdiagramm eines Verfahrens zur Steuern einer steuerbaren Energiequelle gemäß einem Ausführungsbeispiel; und

Fig. 9    ein schematisches Flussdiagramm eines weiteren Verfahrens zur Steuern einer steuerbaren Energiequelle gemäß einem Ausführungsbeispiel.

Bevor nachfolgend Ausführungsbeispiele der vorliegenden Erfindung im Detail anhand der Zeichnungen näher erläutert werden, wird darauf hingewiesen, dass identische, funktionsgleiche oder gleichwirkende Elemente, Objekte und/oder Strukturen in den unterschiedlichen Figuren mit den gleichen Bezugszeichen versehen sind, so dass die in unterschiedlichen Ausführungsbeispielen dargestellte Beschreibung dieser Elemente untereinander austauschbar ist bzw. aufeinander angewendet werden kann.

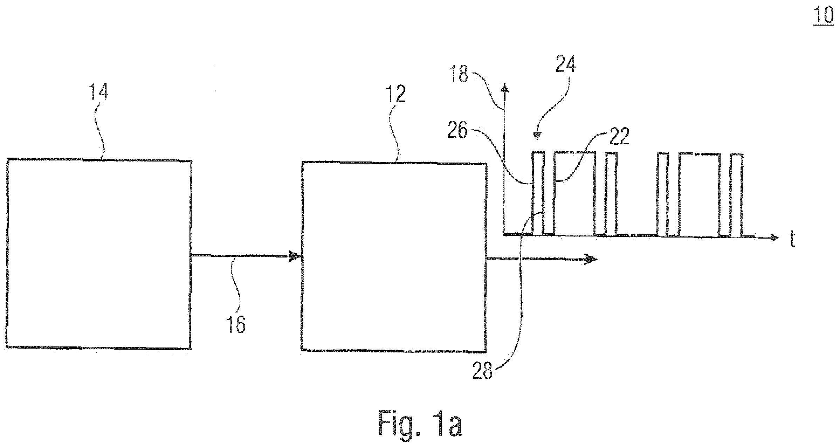

Fig. 1a zeigt ein schematisches Blockschaltbild eines Umrichters 10, der eine steuerbare Energiequelle 12 und eine Steuereinheit 14 aufweist. Die Steuereinheit 14 ist mit der steuerbaren Energiequelle 12 über eine drahtgebundene oder drahtlose Verbindung 16 verbunden und ausgebildet, um die steuerbare Energiequelle 12 über die Verbindung 16 zu steuern. Die steuerbare Energiequelle 12 ist ausgebildet, um eine elektrische Größe 18 auszugeben. Bei der elektrischen Größe 18 kann es sich beispielsweise um eine elektrische Spannung, einen elektrischen Strom oder um eine Menge an Ladung, etwa eine Anzahl von Ladungsträgern handeln. Nachfolgende Ausführungen beziehen sich auf Ausgestaltungen derart, dass die steuerbare Energiequelle 12 eine elektrische Spannung ausgibt. Es versteht, dass durch eine Konvertierung eines elektrischen Stroms und/oder einer elektrischen Ladungsmenge gleiche oder vergleichbare Effekte erhalten werden können, das bedeutet, obwohl die steuerbare Energiequelle 12 nachfolgend als steuerbare Spannungsquelle beschrieben ist, gelten dieselben Ausführungen ohne Einschränkungen auch für eine steuerbare Stromquelle und/oder eine steuerbare Ladungsquelle.

Die Steuereinheit 14 ist ausgebildet, um die steuerbare Energiequelle 12 so zu steuern, dass die steuerbare Energiequelle 12 die elektrische Größe 18 so ausgibt, dass vor einer ersten Flanke 22, die in einem Verlauf der elektrischen Größe 18 einen Wechsel zwischen einem ersten Pegel $L_1$ und einem zweiten Pegel

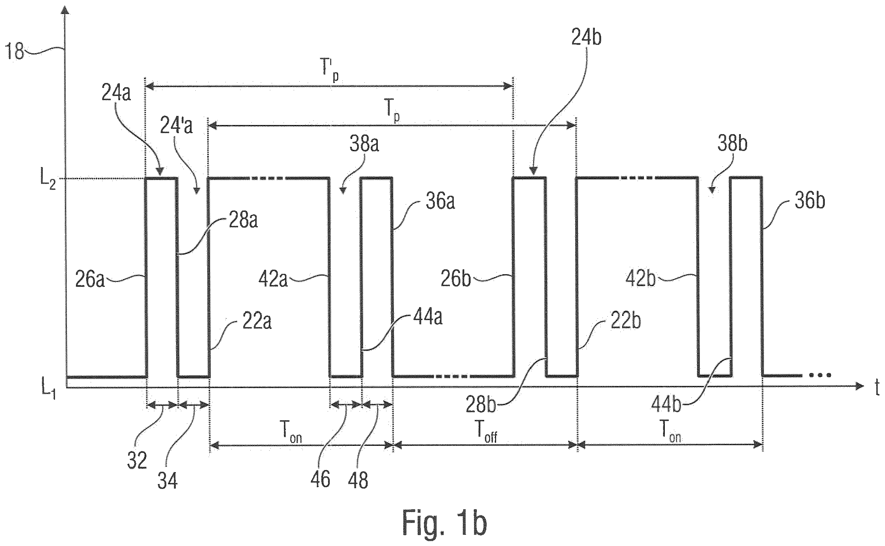

$L_2$ beschreibt, ein Impuls 24 ausgegeben wird, der eine zweite Flanke 26 und eine dritte Flanke 28 des Verlaufs aufweist, wie es anhand der Fig. 1b detailliert dargestellt ist.

Fig. 1b zeigt eine schematische Ansicht des in Fig. 1a dargestellten Verlaufs der elektrischen Größe 18 über die Zeit t in einem höheren Detailgrad.

Die steuerbare Energiequelle 12 kann ausgebildet sein, um die elektrische Größe 18 als pulsweitenmoduliertes Signal (PWM-Signal) auszugeben. Ein PWM-Signal kann als Signal verstanden werden, das zwischen zumindest dem ersten Pegel $L_1$ und dem zweiten Pegel $L_2$ wechselnde Pegel aufweist, wobei ein geringerer Pegel, etwa der Pegel $L_1$ als AUS-Pegel und ein höherer Pegel, etwa der Pegel $L_2$ als AN-Pegel verstanden werden kann. Eine Taktperiode oder Periodendauer $T_p$ eines PWM-Signals kann eine Zeitdauer $T_{on}$ aufweisen, in der der höhere Pegel anliegt und eine Zeitdauer $T_{off}$ aufweisen, in der der geringere Pegel anliegt. Die Steuereinheit 14 kann ausgebildet sein, um vor einem Wechsel zwischen der AUS-Phase in die AN-Phase, der durch die Flanke 22a erzeugt wird, den Impuls 24a auszugeben. Wie es durch die Zeitdauer $T'_p$ dargestellt ist, kann dies dazu führen, dass mit der Zeitdauer $T'_p$ von der Flanke 26a des Impulses 24a beabstandet eine gleiche Flanke 26b eines weiteren Impulses 24b angeordnet ist, der vor einem mit der Periodendauer $T_p$ zeitversetzten Flanke 26b angeordnet ist. Die Periodendauer $T'_p$ kann der Zeit- oder Periodendauer $T_p$ entsprechen. Wie es aus der Fig. 1b hervorgeht, kann ohne Einschränkungen der Impuls auch nach der PWM-Flanke angeordnet sein, bspw. könnte die Flanke 26a die PWM-Flanke und die Flanken 28a und 22a zwei auf einander folgende Impulsflanken des Impulses sein. Anders ausgedrückt bedeutet dies, dass obwohl die hierin beschriebenen Ausführungsbeispiel so beschrieben sind, dass zeitlich vor einem positiven PWM-Flankenwechsel ein positiver Puls vorgelagert ist, dies äquivalent auch so implementiert werden kann, dass nach dem positiven PWM-Flankenwechsel ein negativer Impuls 24'a angeordnet ist und andersherum.

Die hierin beschriebenen vorteilhaften Ausgestaltungen und Effekte basieren unter anderem auf der Aufeinanderfolge von positiven oder negativen Flanken der elektrischen Größe 18, was äquivalent durch eine Vorlagerung oder Nachlagerung eines Impulses erhalten werden kann.

Der Impuls 24 kann eine zeitliche Dauer 32 aufweisen und mit einem zeitlichen Abstand 34 zu der ersten Flanke 22 angeordnet sein. Der zeitliche Abstand 34 kann einen Wert von 25 %, 15 % oder 10 % der Taktperiodendauer $T_p$ betragen. Alternativ oder zusätzlich kann die zeitliche Dauer 32 einen Wert von 25 %, 15 % oder 10 % der Taktperiodendauer $T_p$ betragen.

Für eine symmetrische Anregung von Schwingungen und Gegenschwingungen kann die zeitliche Dauer 32 und der zeitliche Abstand 34 innerhalb eines Toleranzbereichs von $\pm 20$ %, $\pm 10$ % oder $\pm 5$ %, bevor-

zugt in etwa 0 % oder exakt 0 % gleich sein. Das bedeutet, dass in einem Beispiel und bei einem Toleranzbereich von 10 %, eine Genauigkeit 10 % und damit eine Größenordnung der Zeit zwischen PWM-Takt und dem Doppelpuls entsprechen kann.

Der Impuls 24 in Fig. 1a bzw. die Impulse 24a und 24b können vor einem Wechsel von dem Pegel $L_1$ auf den höheren Pegel $L_2$ angeordnet sein. Vor einem Wechsel von dem Pegel $L_2$ auf den Pegel $L_1$ mit einer Signalverlaufsflanke 36a bzw. 36b zum Wechsel zwischen der AN-Phase und der AUS-Phase kann ein entsprechend negativer Impuls 38a bzw. 38b angeordnet sein, auf den gleiche, vergleichbare bzw. dieselben Kriterien anwendbar sind, wie sie im Zusammenhang mit dem Impuls 24 bzw. 24a und 24b beschrieben sind. Das bedeutet, dass der Impuls 38a eine fünfte Flanke 42a und eine sechste Flanke 44a und der Impuls 38b eine fünfte Flanke 42b und eine sechste Flanke 46b aufweisen können, die zeitlich vor der Flanke 36a bzw. 36b angeordnet sind. Der Impuls 38a kann eine Impulsdauer 46 aufweisen, die gleich sein kann wie die Impulsdauer 32, da ein Betrag einer Spannungsdifferenz zwischen dem Pegel $L_1$ und dem Pegel $L_2$ bei einem inversen Wechsel identisch ist. Ebenso kann ein Abstand 48 zwischen dem Impuls 38a und der Flanke 36a gleich sein wie der zeitliche Abstand 34. Das bedeutet, dass die Steuereinheit 14 ausgebildet sein kann, um die steuerbare Energiequelle 12 so zu steuern, dass diese die elektrische Größe 18 so ausgibt, dass vor der vierten Flanke 36, die in dem Verlauf der elektrischen Größe 18 einen Wechsel zwischen dem Pegel $L_2$ und dem Pegel $L_1$ beschreibt, ein zweiter Impuls ausgegeben wird, etwa der Impuls 38a und/oder 38b, der eine fünfte und eine sechste Flanke 42a, 44a bzw. 42b, 44b des Verlaufs aufweist.

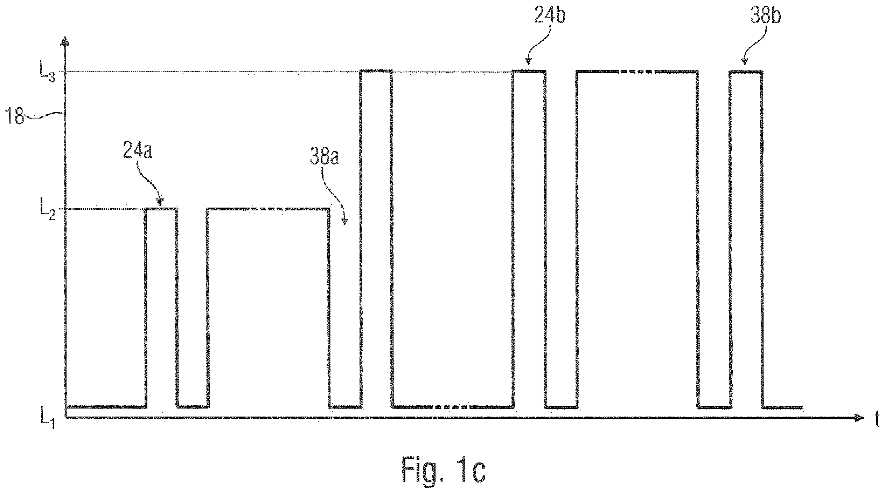

Wie es anhand der Fig. 1c illustriert ist, kann anstelle eines Wechsels von dem Pegel $L_2$ zu dem Pegel $L_1$ auch ein Wechsel zu einem anderen Pegel $L_3$ erfolgen. Der Pegel $L_3$ kann größer oder kleiner sein als der Pegel $L_2$ und/oder größer oder kleiner sein als der Pegel $L_1$. (GGF. Erweiterung der Zeichnung: Pulse können auch zwischen L2 und L3 liegen!). Das bedeutet, dass die hierin beschriebenen Impulse, was auch als Doppelpulsverfahren bezeichnet werden kann, ohne dass hierdurch eine Einschränkung auf zwei Pulse entsteht, auch für Multilevel Wandler angewendet werden kann.

Die Pulsmuster (Zeitdauern/Abstände(Spannungspegel) sind dabei nicht nur auf den Wechsel zwischen zwei Pegel beschränkt. Unter Anpassung der Pulsbreiten kann der Doppelpuls auch mit von vor- und nach dem Flankenwechsel anliegenden Pegeln geformt werden, etwa stationär L1, kurzzeitig L3 und dann stationär L2 - oder alle anderen Reihenfolgen.

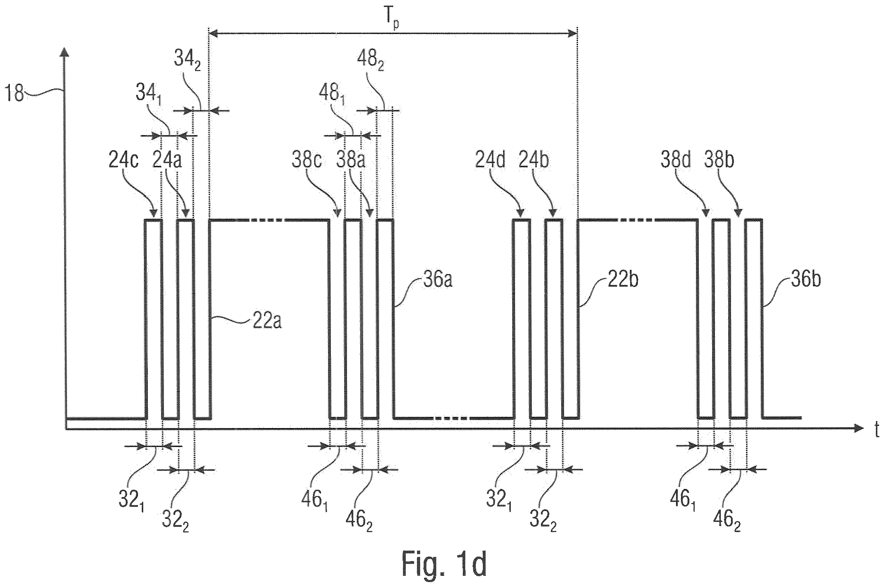

Wie es anhand von Fig. 1d dargestellt ist, kann vor der PWM-Flanke 22a und/oder 22b zumindest ein weiterer Impuls 24c bzw. 24d angeordnet sein. Obwohl der Impuls 24c zeitlich vor dem Impuls 24a und der Impuls 24d zeitlich vor dem Impuls 24b dargestellt ist, kann auch eine andere zeitliche Reihenfolge implementiert werden. In ähnlicher Weise oder in gleicher Weise können auch vor den Flanken 36a und/oder 36b zumindest zwei Impulse 38a und 38c bzw. 38b und 38d angeordnet sein. Zur Bestimmung einer zeitlichen Gesamt-Impulsdauer können Einzelimpulsdauern $32_1$ und $32_2$ bzw. $46_1$ und $46_2$ addiert werden. Für eine Summe der Zeitdauern $32_1$ und $32_2$ der Impulse 24a und 24c und/oder für eine zeitliche Gesamtdauer der Impulse 38a und 38c können die Ausführungen bezüglich der zeitlichen Dauern 32 und/oder 46 im Zusammenhang mit der Fig. 1b gelten. Ebenso kann für eine zeitliche Summe der Abstände oder Pausen zwischen den Impulsen, das bedeutet, Zeitdauern $34_1$ und $34_2$ das für den zeitlichen Abstand 34 Erläuterte gelten. Alternativ oder zusätzlich kann für einen zeitlichen Abstand $48_1$ zwischen dem ersten und zweiten Impuls 38a und 38c sowie für den zeitlichen Abstand $48_2$ zwischen dem Impuls 38a und der Flanke 36a zusammengenommen das für den zeitlichen Abstand 48 Erläuterte gelten. Das bedeutet, dass die Steuereinheit 14 ausgebildet sein kann, um die steuerbare Energiequelle 12 so zu steuern, dass diese das PWM-Signal so ausgibt, dass das PWM-Signal einen Takt mit der Taktperiodendauer $T_p$ aufweist. Eine Summe von zeitlichen Dauern der zumindest zwei Impulse, das bedeutet, der zeitlichen Dauern $32_1$ und $32_2$ und/oder der zeitlichen Dauern $46_1$ und $46_2$ kann höchsten 25 %, 15 % oder 10 % der Taktperiodendauer betragen.

Ebenso kann eine Summe der Zeitdauern $32_1$ und $32_2$ sowie eine Summe der Zeitdauern $34_1$ und $34_2$ innerhalb des zuvor erläuterten Toleranzbereichs gleich sein. Selbiges gilt für die Summen der Zeitdauern $46_1$ und $46_2$ verglichen mit den Zeitdauern $48_1$ und $48_2$.

Der Umrichter 10 kann ausgebildet sein, um mittels des zumindest einen Impulses 24 bzw. 24a und 24c oder 24b und 24d, der der PWM-Flanke 22a bzw. 22b vorangestellt ist, in einem Filter eine Filterantwort zu erzeugen, indem sich die Filterantwort auf den zumindest einen Impuls und die Filterantwort auf die Flanke 22a bzw. 22b so überlagern, dass die Schwingungen in der Filterantwort zumindest teilweise kompensiert werden.

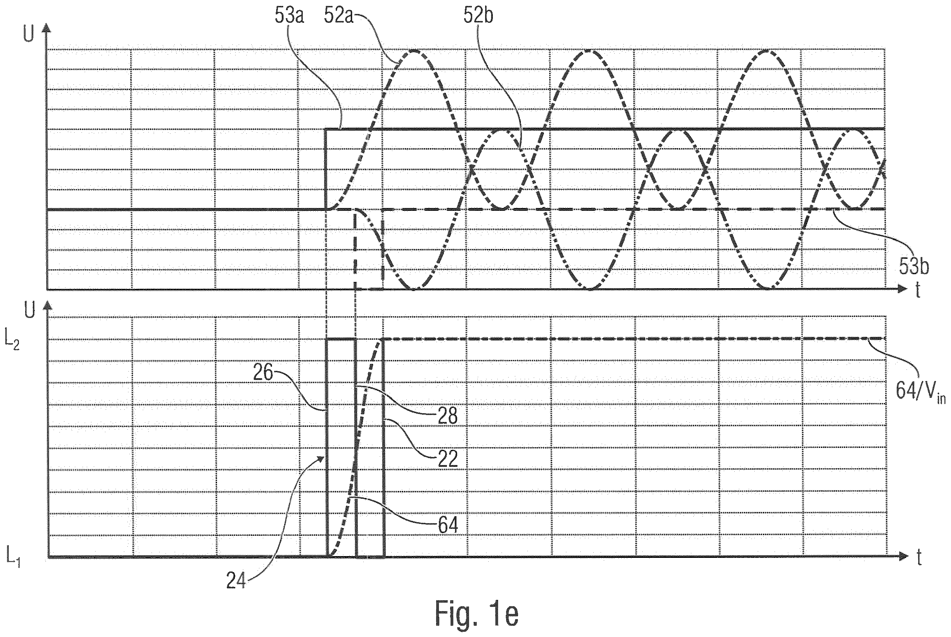

Dies ist in Fig. 1e dargestellt. Fig. 1e zeigt im oberen Teil eine beispielhafte Überlagerung einer Filterantwort 52a, die beispielsweise basierend auf der Flanke 26 des Impulses 24 in dem Filter erhalten werden kann und einer Filterantwort 52b, die beispielsweise basierend auf der Flanke 28 des Impulses 24 in dem Filter erhalten werden kann. Im unteren Teil sind die Filtereingangssignale, d. h., der Impuls 24 sowie der Flankenwechsel 22 über dieselbe Zeitachse t schematisch dargestellt.

Die beiden Filterantworten 52a und 52b überlagern miteinander, so dass eine resultierende Gesamtfilterantwort im Wesentlichen schwingungsfrei ausgestaltet sein kann. Dies ermöglicht eine Vorkonditionierung des Filters, so dass ein nachfolgender PWM-Wechsel störungsreduziert oder störungsfrei über das Filter übertragen werden kann, wie es anhand eines Ausgangssignals 64 des Filters illustriert ist, das nach der Flanke 22 im Wesentlichen einer Spannung $V_{in}$ entspricht, die an den Filtereingang anlegbar ist und die Überlagerung der PWM mit dem Impuls 24 bezeichnen kann. Die Darstellung der Flankenfolgen PWM/Puls kann, wie bereits beschrieben auch anders zugeordnet werden, ohne die hierin enthaltene Lehre zu verändern. In der Darstellung der Fig. 1e können auch drei einzelne Flanken überlagert werden oder mehr. Ein Puls kann dem Step/PWM-Flankenwechsel zeitlich folgen. Dies kann anstelle von "Kompensation durch einen Gegenpuls nach dem Pegelwechsel" mit "Vorkonditionierung durch einen Puls vor dem eigentlichen Pegelwechsel" beschrieben werden. Sowohl mathematisch als auch in der Filterantwort kann ein identisches Ergebnis erhalten werden.

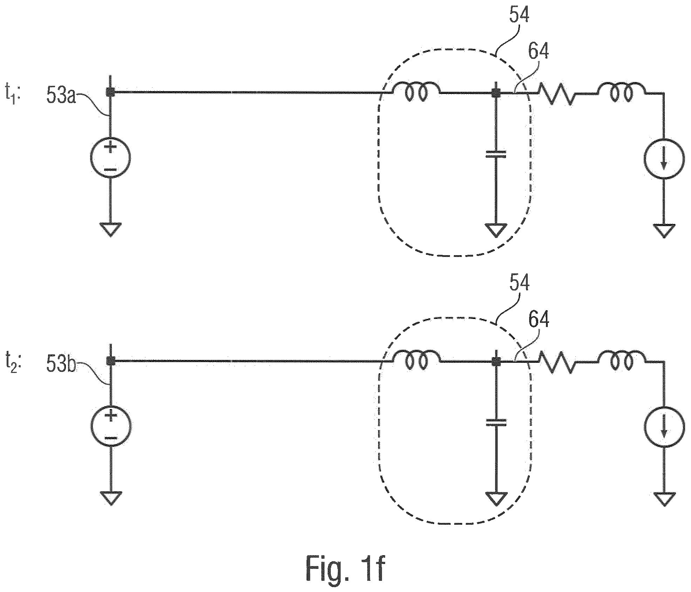

Die Pulsflanken 26 und 28 können, wie es anhand der schematischen Darstellung der Vorrichtung zur Bereitstellung der Pulsflanken Fig. 1f dargestellt ist durch zu den Zeitpunkten $t_1$ und $t_2$ abgegebene Signale einer Spannungsquelle dargestellt werden.

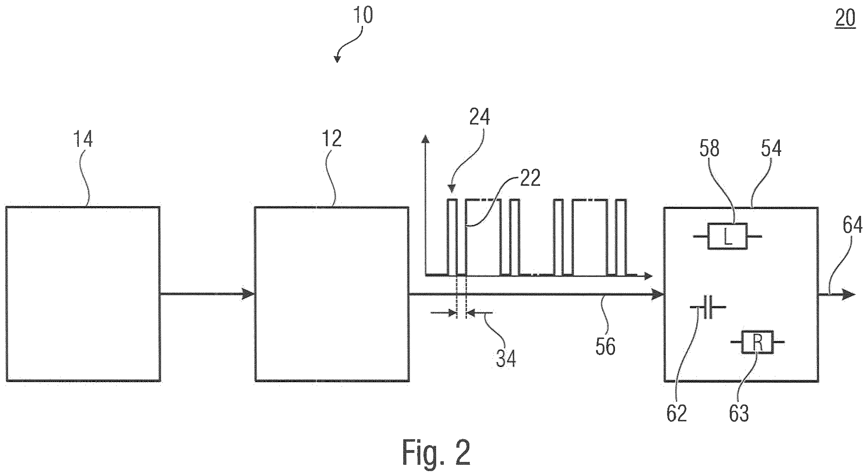

Fig. 2 zeigt ein schematisches Blockschaltbild einer Vorrichtung 20 gemäß einem Ausführungsbeispiel. Die Vorrichtung 20 umfasst den Umrichter 10 und ein Filter 54, das mit der steuerbaren Energiequelle verbunden ist und ausgebildet ist, um ein Signal 56, das von der steuerbaren Energiequelle 12 ausgegeben werden kann, zu filtern. Das Filter 54 kann als beliebiges Filter implementiert werden und kann beispielsweise ein induktives Element 58 und/oder ein kapazitives Element 62 umfassen. Alternativ oder zusätzlich kann zumindest eines der Elemente 58 und/oder 62 als Ohmsches Element implementiert sein. Das Filter 54 kann eine Grenzfrequenz $f_G$ aufweisen, die sich in bekannter Weise durch die Konfiguration des Filters 54 bestimmt. In der dargestellten Konfiguration umfassend das induktive Element 58 und das kapazitive Element 62 kann das Filter 54 beispielsweise als Tiefpass ausgebildet sein. Die Steuereinheit 14 kann ausgebildet sein, um die steuerbare Energiequelle 12 so zu steuern, dass der Impuls 24 den zeitlichen Abstand 34 zu der Flanke 22 derart aufweist, dass die im Zusammenhang mit der Fig. 1e beschriebenen Filterantworten des Filters basierend auf dem Impuls und basierend auf der Flanke 22 sich zumindest teilweise kompensieren. Wie es in der Fig. 1e ersichtlich ist, führt der zeitliche Abstand 34 zu einer hiervon zumindest beeinflussten oder bestimmten Phasenlage zwischen den Filterantworten 52a und 52b.

Das Filter 54 kann als eigenes Vorrichtungs-Filter mit speziell ausgelegten Elementen, etwa dem induktiven Element 58, dem kapazitiven Element 62 und/oder einem resistiven Element gebildet sein. Wie es nachfolgend detailliert erläutert werden wird, ist es aber ebenso möglich, eines oder mehrere derartiger Wirkelemente durch parasitäre Komponenten anderer Teile oder Elemente in der Vorrichtung 20 oder einem hieraus gebildeten System zu implementieren. So ist es beispielsweise möglich, dass ein Verbindungskabel zwischen der steuerbaren Energiequelle 12 und einer hiervon betriebenen elektrischen Last einen in dem Filter wirksamen Widerstandswert, einen in dem Filter 54 wirksamen Induktivitätswert und/oder einen in dem Filter 54 wirksamen Kapazitätswert bereitstellt, so dass das Filter 54 mit entsprechend geringer ausgelegten Elementen oder ggf. ohne separat angeordnete derartige Elemente ausgelegt werden kann.

Das Filter 54 kann als ein ein Tiefpass implementierendes LC-Filter ausgeführt sein. Eine Grenzfrequenz $f_G$ kann sich dann aus

$$f_G = \frac{1}{2\pi\sqrt{LC}}$$

Ergeben, wobei L einen Induktivitätswert und C einen Kapazitätswert des Filters bezeichnet. Alternativ kann das Filter 54 auch als RC-Filter gebildet sein, wodurch sich eine Grenzfrequenz von beispielsweise

$$f_G = \frac{1}{2\pi RC}$$

ergeben kann, wobei R einen Widerstandswert bezeichnet. Alternativ kann das Filter 54 beispielsweise als ein ein Hochpass implementierendes RL-Filter gebildet sein, womit sich eine Grenzfrequenz von beispielsweise

$$f_G = \frac{R}{2\pi L}$$

ergeben kann, wobei auch andere Filterkonfigurationen wie etwa Bandpassfilter, Bandsperrfilter, LLC-Filter (zwei parallel geschaltete Induktivitäten mit einem dazwischen geschalteten Kapazitätswert) oder LCL-Filter (zwei seriell geschaltete Induktivitäten mit einem dazwischen gegen ein Bezugspotential geschalteten Kapazitätswert). Es versteht sich, dass beliebige andere Kombinationen aus Widerstandswerten (R), Induktivitätswerten (L) und/oder Kapazitätswerten (C) in dem Filter berücksichtigt oder implementiert werden können. Der Induktivitätswert des Filters, etwa des induktiven Elements 58, kann einen beliebigen Wert aufweisen, beispielsweise 1 nH bis 10 µH. Ein Kapazitätswerts des Filters, etwa des kapazitiven Elements des kapazitiven Elements 62, kann ebenfalls einen beliebigen Wert aufweisen, etwa 100 pF, bis 1 µF. Der Widerstandswert des Filters kann einen beliebigen Wert aufweisen, beispielsweise 10 µOhm bis 10 Ohm. Einige, mehrere oder alle der induktiven, resistiven oder kapazitiven Elemente können ganz oder teilwiese durch parasitäre Werte von mit der steuerbaren Energiequelle verbundenen Schaltungselementen wie Kabeln, Wicklungskapazität, Streuinduktivität, Kopplungskapazität und weiteren Elementen der elektrischen Lasten ausgeführt sein.

Die Steuereinheit 14 kann ausgebildet sein, um die steuerbare Energiequelle 12 so zu steuern, dass eine zeitliche Dauer 32 oder 46 des Impulses 24 oder 38 innerhalb eines Toleranzbereichs von $\pm 50$ %, $\pm 30$ %, $\pm 10$ % oder $\pm 5$ % dem Kehrwert der sechsfachen Filterfrequenz/Grenzfrequenz des Filters 54 entspricht, das bedeutet dem Wert ($1/(f_G*6)$). Dieser Toleranzbereich kann alternativ oder zusätzlich auch als absoluter Zeitwert beschrieben sein und bspw. $\pm 100$ ns, $\pm 50$ ns oder $\pm 10$ ns betragen, das bedeutet, je schneller die Flankenwechsel sind, desto höher der relative Toleranzbereich, besonders wenn die Flanke selbst bei sehr kurzen Pulsen schon nicht mehr als ideal anzunehmen ist. Der Wert von

$$t_p = \frac{1}{f_G * 6}$$

liefert ohne Berücksichtigung von Abweichungen einen mathematisch exakten Wert zur Aufladung des Filters, da der Strom vor und nach dem Impuls genau identisch sein soll, die Flanken beliebig steil sind und keine Verluste auftreten. Abweichungen innerhalb des Toleranzbereichs liefern Abweichungen von dem stabilen Zustand, wobei dies innerhalb der Toleranzen vertretbar sein kann, wobei Abweichungen nachgeregelt oder nachjustiert werden können, bspw. manuell oder durch eine Überwachung mittels der Steuereinheit 14.

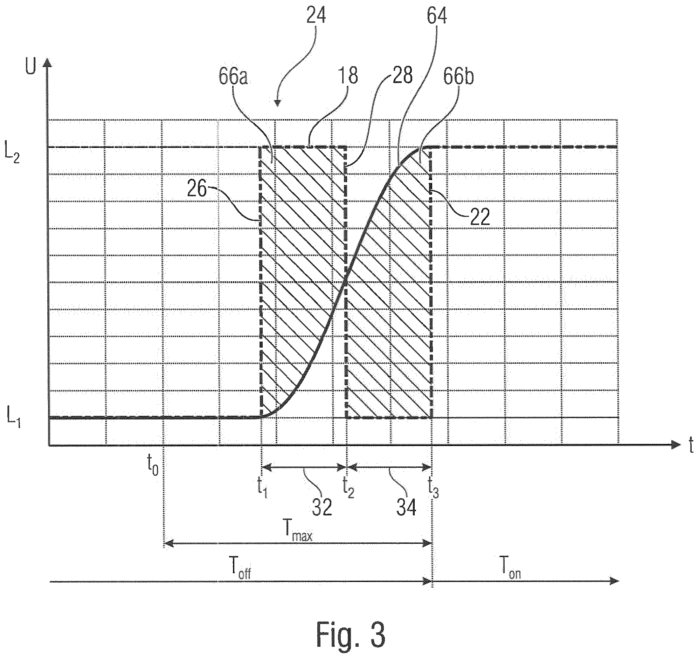

Ein Ausgangssignal 64 des Filters 54 wird beispielhaft anhand von Fig. 3 erläutert. Fig. 3 zeigt ein schematisches Diagramm, dass die von der steuerbaren Energiequelle 12 bereitgestellte elektrische Größe 18, beispielsweise die PWM-Spannung, und das Filterausgangssignal 64 an einer gemeinsamen Zeitachse t darstellt. Das Filterausgangssignal 64 ist ebenfalls auf einen Spannungswert bezogen, so dass sowohl die elektrische Größe 18 als auch das Filterausgangssignal 64 an einer Spannungs-Ordinate U dargestellt sind. Zu einem Zeitpunkt $t_1$ kann die Steuereinheit 14 ausgebildet sein, um die steuerbare Energiequelle 12 so zu steuern, dass diese beginnt, den Impuls 24 auszugeben, das bedeutet, es tritt die Flanke 26 am Ausgang der steuerbaren Energiequelle 12 auf. Dies führt dazu, dass ein Strom in das Filter 54 fließt. Dies führt zu einem allmählichen Aufladen oder Umladen des Filters 54, was durch die ansteigende Flanke des Filterausgangssignals 64 erkennbar ist. Nach der Zeitdauer 32 und zu einem Zeitpunkt $t_2$ kann die Steuereinheit 14 ausgebildet sein, um die steuerbare Energiequelle 12 so zu steuern, dass der Impuls 24 endet und die Flanke 28 auftritt, das bedeutet, es kann zu dem Ausgangslevel $L_1$ zurückgekehrt werden.

Nach dem zeitlichen Abstand 34 kann die Steuereinheit 14 ausgebildet sein, um die steuerbare Energiequelle 12 so zu steuern, dass diese die Flanke 22 bereitstellt. Bei idealer Auslegung des Impulses 24 kann das Filter 54, wie es durch das Filterausgangssignal 64 dargestellt ist, zum Zeitpunkt $t_3$, zu dem die Flanke 22 bereitgestellt wird, umgeladen oder aufgeladen sein. Eine Zeit-Spannungs-Fläche 66a während des Impulses 24 und eine Zeit-Spannungs-Fläche 66b während des zeitlichen Abstandes 34 während der der Impuls 24 inaktiv ist, kann in etwa gleich groß sein, wobei die Zeit-Spannungs-Fläche 66a mit einem positiven Vorzeichen und die Zeit-Spannungs-Fläche 66b mit einem negativen Vorzeichen berücksichtigt werden kann (oder anders herum), so dass insgesamt eine kombinierte Zeitspannungsfläche null oder zumindest nahe null sein kann. Dies bewirkt, dass der Strom, etwa durch das induktive Element 58 des Filters 54 vor und nach dem Impuls 24 identisch ist. Der Spulenstrom durch das induktive Element 58 kann somit einem aktuellen Phasenstrom entsprechen. Dies wird in hoher Güte erreicht, wenn der Impuls 24, das heißt die zeitliche Dauer 32 so lange ist wie der zeitliche Abstand (Pause) 34.

Dies kann anhand einer Erläuterung der der Schwingkreise verdeutlicht werden: Findet bspw. zum Zeitpunkt t=0 eine stufenförmige Anregung des Filters statt, so hat die Spannung am Ausgang bei t=0 das Level L1. Würde man die Schwingung mit der entsprechenden Amplitude $U_{oszi}$ = U(L2)-U(L1) frei oszillieren lassen, so würde die Spannung nach 90° ($\pi/2$) bei L2 liegen, nach 180° ($\pi$) würde diese überschwingen auf einen Spitzenwert von U(L2) + $U_{oszi}$. Nach 360° ($2\pi$) wäre die Schwingung wieder bei U(L1). Die Formel für den Spannungsverlauf lautete daher passend zu Fig 3:

$$U(t) = U(L_2) + \cos(t \cdot 2\pi f) U_{oszi}$$

Ziel dieses Filters ist jedoch keine permantene Oszillation, sondern ein definiertes Umladen des Ausgangs. Zu diesem Zweck muss am Induktiven Bauelement, wie schon beschrieben, zunächst eine Zeit-Spannungsfläche 66a und eine gleich große Zeit-Spannungsfläche 66b mit entgegengesetztem Vorzeichen an dieser Spule anliegen. Durch die gleich großen Flächen kann auch der Strom vor und nach diesem Doppelpuls identisch sein. (z.B. entsprechend dem momentanem Laststrom).

Anhand Fig. 3 ist zu sehen, dass diese Zwei Flächen symmetrisch zueinander ausgestaltet sind. Der Wechsel zwischen erster Flanke 26 und zweiter Flanke 28 findet bspw. genau in der Mitte, d.h. bei einem Filterausgang mit dem Wert (L1+L2)/2, statt. Es ist also auch genau der Zeitpunkt der Schwingung, bei der der Momentane wert der Oszillation genau 50%, bzw. ½ der Amplitude, ist, an diesem Punkt gilt:

$$\varphi = \cos^{-1}\left(\frac{1}{2}\right) = 60° \; bzw. \frac{1}{3}\pi$$

Aus dem Winkel $\varphi$ ergibt sich direkt auch die Zeitdauern der Pulse

$$t_p = \frac{\varphi}{2\pi f} = \frac{1}{6f}$$

Entsprechend der Formeln ist zu sehen, dass sich die gesamte Flanke nicht wie eine Sinusschwingung, sondern nur sinusähnlich zusammensetzt. Genau genommen setzt sich die Flanke aus zwei Sinus-Schwingungs-Abschnitten zusammen. Jeder der zwei Abschnitte kann bspw. lediglich einen 60° Abschnitt aus einer echten Sinusoszillation um den Bezugspunkt L2 darstellen. Zum Wechselzeitpunkt $t_2$ (Flanke 28) springt die Kurve in eine zweite Sinusoszillation mit einem anderen Bezugspunkt (L1). An der Flanke 28 entsteht daher eine Unstetigkeit in der zweiten Ableitung der Ausgangsgröße, ist also nicht frei von harmonischen, auch wenn dies "kaum sichtbar" ist.

Dies kann auch so verstanden werden, dass in diesem Fall der Impuls 24 die Länge 32 aufweist und somit genau die Spannungszeitfläche 66a aufspannt, welche nötig ist, um den ersten Quadranten einer LC-Schwingung bei UZK/2 zu durchlaufen. Aufgrund der Symmetrieeigenschaft einer angeregten Sinusschwingung ist dabei beispielsweise bei einer anzusteuernden Ausgangsspannung des Filters (Pegel $L_2$) von 800 V lediglich ein Sechstel der Filtergrundfrequenz bzw. Filtergrenzfrequenz nötig.

Der Kehrwert $1/f_G$ der Filtergrenzfrequenz $f_G$ ermöglicht den Erhalt einer Zeitspanne $T_{max}$. Ist es beispielsweise basierend auf dem PWM-Signal beabsichtigt, von der AUS-Phase in die AN-Phase zu wechseln, so ergibt sich basierend auf dem Kehrwert die maximale Zeitspanne $T_{max}$ zwischen dem Zeitpunkt $t_3$ und einem davor angeordneten Zeitpunkt $t_0$, innerhalb derer der Impuls 24 anzuordnen ist, um in einer hohen Güte die Vorab-Anregung des Filters bereitzustellen. Wird gleichzeitig die Auslegung derart gewählt, dass die Zeitdauer 32 gleich ist wie der zeitliche Abstand 34, so ergibt sich damit auch eine maximale zeitliche Länge des Impulses 24, nämlich zu $T_{max}/2$ oder kürzer.

Durch die Auslegung des Impulses 24 derart, dass die Zeitspannungsflächen 65a und 66b innerhalb eines Toleranzbereichs von 5 %, 3 % oder 1 % ggf. 0 % gleich groß sind, kann die Steuereinheit 14 ausgebildet sein, um die steuerbare Energiequelle 12 so zu steuern, dass ein durch ein induktives Element, etwa das induktive Element 58, des Filters 54 fließender Strom zu einem Beginn des Impulses 24 mit einer Toleranz von ±5 %, ±3 %, ±1 % ggf. ±0 % gleich einem durch das induktive Element 58 des Filters 54 fließenden Strom zum Zeitpunkt der ersten Flanke 22 ist.

Es ist basierend hierauf ferner möglich, dass die Flanke des Filterausgangssignals 64 zwischen den Zeitpunkten $t_1$ und $t_3$ hälftig mit dem Impuls 24 zeitlich überlappt, das bedeutet, dass die Steuereinheit 14 ausgebildet sein kann, um die steuerbare Energiequelle 12 so zu steuern, dass die Zeitdauer 32 mit einer Toleranz von ±10 %, ±5 % oder ±2 % der Hälfte der zeitlichen Dauer der Flanke des Filterausgangssignals 64 entspricht, das bedeutet, $(t_3-t_1)/2 \pm 10$ %, ±5 % oder ±2 %. Dieselben Ausführungen sind ohne Einschränkungen auch für den Wechsel zwischen der AN-Phase und der AUS-Phase gültig.

Wie es vorangehend beschrieben ist, können zusätzlich zu dem Impuls 24 zumindest ein weiterer Impuls vor der Flanke 22 angeordnet sein. Zusätzliche Impulse können eine geringere Steilheit der Flanke in dem Verlauf 64 ermöglichen, was vorteilhaft ist. Ferner können kurze Pulse, etwa im Bereich von 10 ns, 50 ns oder 100 ns ein sehr schnelles Antakten ermöglichen, so dass eine Leitungsimpedanz, eine Leitungskapazität, ein Leitungskapazitätsbelag, eine Leitungsinduktivität und/oder eine Leitungslaufzeit genutzt wird, um das Filter zu realisieren. Dies ermöglicht die Herstellung einer gewünschten Ausgangsimpedanz passend zum Kabel und/oder Motor. Alternativ oder zusätzlich ermöglicht dies eine Reduzierung der Überspannung am Ende einer langen Motorleitung.

In anderen Worten zeigt der Verlauf 18 die Spannung an einem idealen Halbbrückenmodul. Der Verlauf 64 stellt die Ausgangsspannung eines Filters dar, was auch die Spannung an einer elektrischen Last sein kann, etwa an einem Motor. Eine Flankensteilheit am Motor, das heißt der Last, ist gegenüber dem Verlauf der Flanke 22 deutlich oder drastisch reduziert, etwa in einer ersten Näherung hin zu einem halben Cosinusverlauf, welcher höhere Frequenzanteile stark unterdrückt und somit problematische hohe Frequenzanteile (EMV-Belastung, Lebensdauer der Isolationsmaterialien, Störausstrahlung, Überschwingen) verhindert.

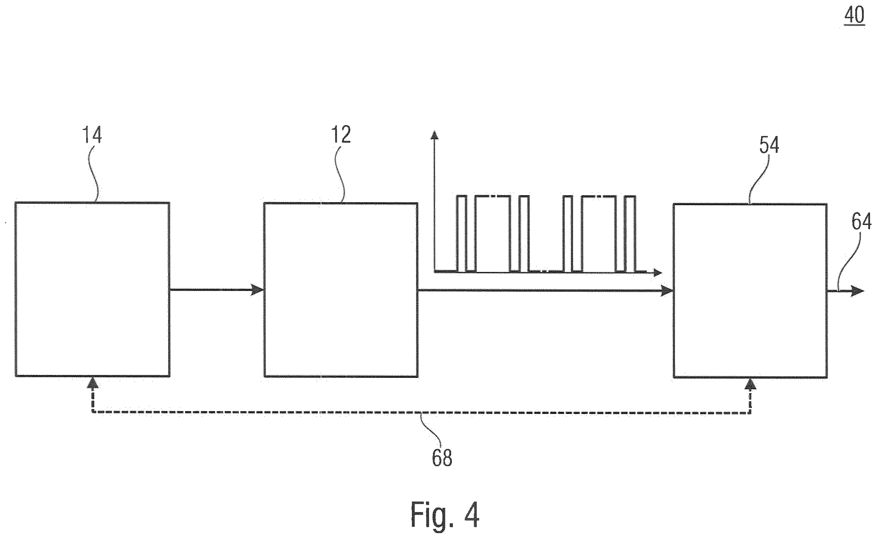

Fig. 4 zeigt ein schematisches Blockschaltbild einer Vorrichtung 40, die gegenüber der Vorrichtung 20 dahin gehend modifiziert ist, dass die Steuereinheit 14 ausgebildet ist, um die Grenzfrequenz $f_G$ des Filters 54 zu bestimmen. Die Steuereinheit 14 ist ferner ausgebildet, um den zeitlichen Abstand 34 und/oder die Zeitdauer 32 basierend auf der bestimmten Grenzfrequenz einzustellen. Hierfür kann die Steuereinheit 14 mittels eines Datensignals 68 Informationen, etwa Messdaten bezüglich der Induktivitätswerte, Kapazitätswerte oder Widerstandswerte erhalten und darauf die Grenzfrequenz bestimmen. Die Anpassung des Timing des Impulses, das heißt dessen Anzahl, dessen Einzel- oder Gesamtdauer sowie des oder der Abstände zwischen den Impulsen und/oder der Flanke 22 kann vorteilhaft sein, um veränderliche Filterkonfigurationen zu berücksichtigen, das heißt den Impuls an veränderliche Filterwerte einzustellen. Dies kann beispielsweise erforderlich oder vorteilhaft sein, wenn basierend auf veränderlichen Umgebungstemperaturen sich Werte ändern oder wenn parasitäre Parameter wie eine Kabelinduktivität oder Kabelkapazität die Filtereigenschaft nennenswert beeinflussen und beispielsweise eine Kabelführung verändert wird, so dass sich damit auch die Filtereigenschaft ändert.

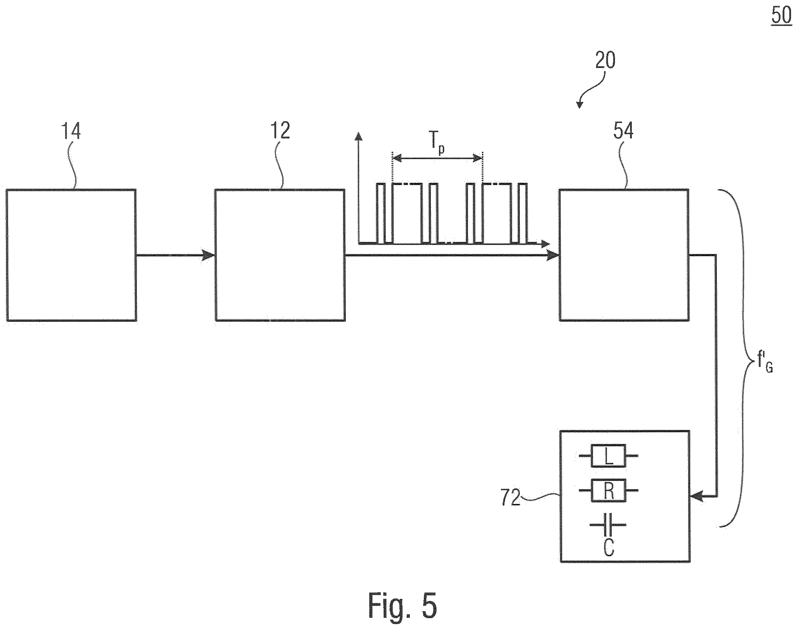

Fig. 5 zeigt ein schematisches Blockschaltbild eines Systems 50, das beispielsweise die Vorrichtung 20 aufweist und ferner eine elektrische Last 72 umfasst, die mit einem Ausgang des Filters 54 verbunden ist. Die elektrische Last 72 weist elektrische Eigenschaften auf, die beispielsweise einen Widerstandswert, einen Induktivitätswert und/oder einen Kapazitätswert oder beliebige Kombinationen hieraus umfassen können, so dass die elektrische Eigenschaft oder die elektrischen Eigenschaften der elektrischen Last 72 zumindest einen Teil eines Resonanzschwingkreises bilden. Das bedeutet, dass die elektrische Eigenschaft der elektrischen Last 72 mit dem Filter 54 in Wechselwirkung tritt, so dass die Grenzfrequenz des Filters 54 durch die elektrische Eigenschaft beeinflusst oder bestimmt ist. Die Grenzfrequenz $f_G$ ist größer als die Taktfrequenz, die auch durch $1/T_p$ ausgedrückt werden kann, das bedeutet, dass die Steuereinheit 14 ausgebildet ist, um die steuerbare Energiequelle 12 derart zu steuern, dass diese die elektrische Größe 18 mit der Taktfrequenz $1/T_p$ von weniger als der Grenzfrequenz $f'_G$ ausgibt, die durch die Kombination des Filters 54 mit der elektrischen Last 72 erhalten wird. An dieser Stelle wird deutlich, dass das Filter 54 selbst oder lediglich für sich allein gestellt, nicht zwingend eine Schwingkreis-Konfiguration bereitstellen muss. Es kann ausreichend sein, wenn dies in Kombination mit der elektrischen Last 72 erfolgt.

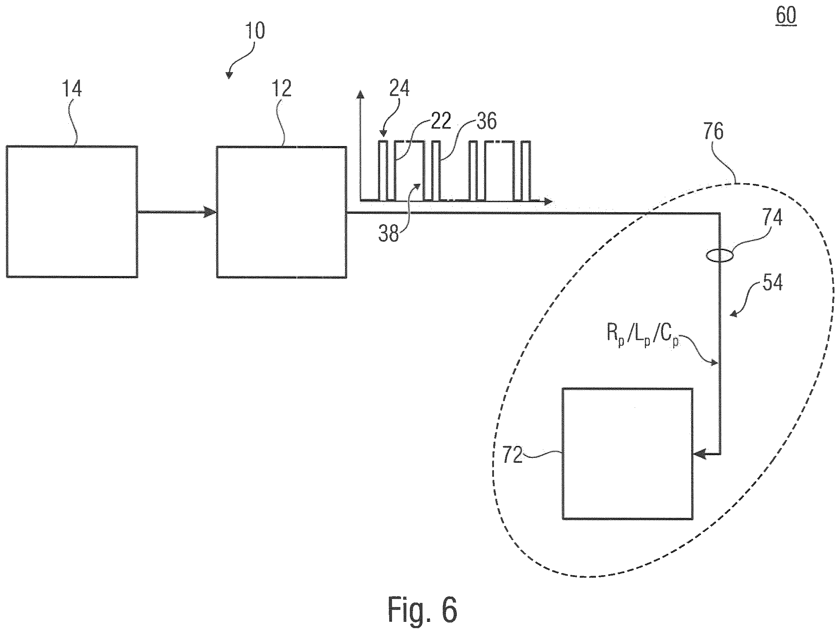

Fig. 6 zeigt ein schematisches Blockschaltbild eines Systems 60 gemäß einem weiteren Ausführungsbeispiel, das den Umrichter 10 umfasst, der mittels eines Kabels 74 mit der elektrischen Last 72 verbunden ist. Das Kabel 74 kann einen Widerstandswert, einen Induktivitätswert und/oder einen Kapazitätswert sowie beliebige Kombinationen hieraus bereitstellen. So kann die elektrische Last beispielsweise ein resistiv, induktiv oder kapazitiv wirkender Motor sein und die Kabelverbindung 74 ein entsprechendes Motorkabel sein. Das Kabel 74 kann eine parasitäre Wicklungskapazität aufweisen, die einen Wert von mehreren Picofarad bis hin in den Nanofarad-Bereich aufweisen kann, etwa zumindest 200 pF, 300 pF oder 500 pF. Alternativ oder zusätzlich kann das Kabel 74 eine Kabelinduktivität aufweisen. Dies ermöglicht es, das Filter 54 unter Ausnutzung der ggf. parasitären elektrischen Eigenschaften des Kabels 74 zu implementieren, das heißt das Filter 54 kann ganz oder teilweise durch die Kabelverbindung 74 implementiert sein. Die Grenzfrequenz des Resonanzschwingkreises kann somit von dem parasitären Kapazitätswert, dem parasitären Induktivitätswert und/oder dem parasitären resistiven Wert des Kabels 74 sowie einem parasitären Kapazitätswert der elektrischen Last, einem parasitären Induktivitätswert der elektrischen Last oder einem parasitären resistiven Wert der elektrischen Last 72 bestimmt sein.

Gemäß einer Ausführungsform ist die Grenzfrequenz des Resonanzschwingkreises von dem Kabel 74 zwischen der elektrischen Last 72 und der steuerbaren Energiequelle 12 bestimmt. Das bedeutet, dass keine oder lediglich vernachlässigbare andere elektrische Eigenschaften angeordnet sind, insbesondere kann hierfür auf eine Anordnung von separaten Filtern verzichtet werden. Die Verbindung, das heißt das Kabel 74 weist einen parasitären Induktivitätswert und einen parasitären Resonanzschwingkreises auf. Die Steuereinheit 14 kann ausgebildet sein, um die steuerbare Energiequelle 12 so zu steuern, dass der parasitäre Schwingkreis 76 umfassend das Kabel 74 und die elektrische Last 72 basierend auf dem Impuls 24 und/oder 38 so angeregt wird, dass der parasitäre Schwingkreis 76 vor dem Impuls 24 bzw. 38 und nach der Flanke 22 bzw. 36 in einem stationären Zustand ist. Dieser kann bspw. so beschrieben werden, dass mit dem erstem Impuls Energie in den Filter-Resonanzkreis eingebracht wird und mit dem zweiten Puls wieder entnommen wird. Das Kriterium für den stationären Zustand kann also auch so formuliert werden: Die Energie des Filters ist nach der dritten Flanke wieder Minimal (die gespeicherte Filterenergie ergibt sich nur noch durch den Laststrom und -Spannung). Oder generell, wie schon häufiger genannt: Stationär heißt, die Oszillation des Filters/parasitärer Werte soll weitgehend unterdrückt sein.

Gemäß einer Ausführungsform kann das Filter 54 als LC-Filter implementiert sein und beispielsweise das induktive Element 58 aufweisen, wobei das induktive Element 58 durch das Kabel 74 implementiert ist. Das bedeutet, dass das kapazitive Element 62 als extra ausgelegtes Filterelement zusätzlich angeordnet werden kann, etwa wenn die parasitäre Wicklungskapazität in dem Kabel 74 nicht ausreichend aus.

Unabhängig davon, ob das kapazitive Elemente des Filters 54 mittels der parasitären Wicklungskapazität oder als kapazitives Element 62 implementiert wird, kann ein Kapazitätswert dieses Elements so gewählt sein, dass unter Verweis auf Fig. 3 die Flankensteilheit einer Flanke, das bedeutet, die Pegeldifferenz $L_2$-$L_1$ dividiert durch die Zeitspanne $t_3$-$t_1$ einen Wert von höchstens 10 kV/$\mu$s aufweist. Gemäß weiteren Ausführungsformen kann die Flankensteilheit einen Wert von höchstens 8 kV/$\mu$s oder höchstens 7 kV/$\mu$s aufweisen.

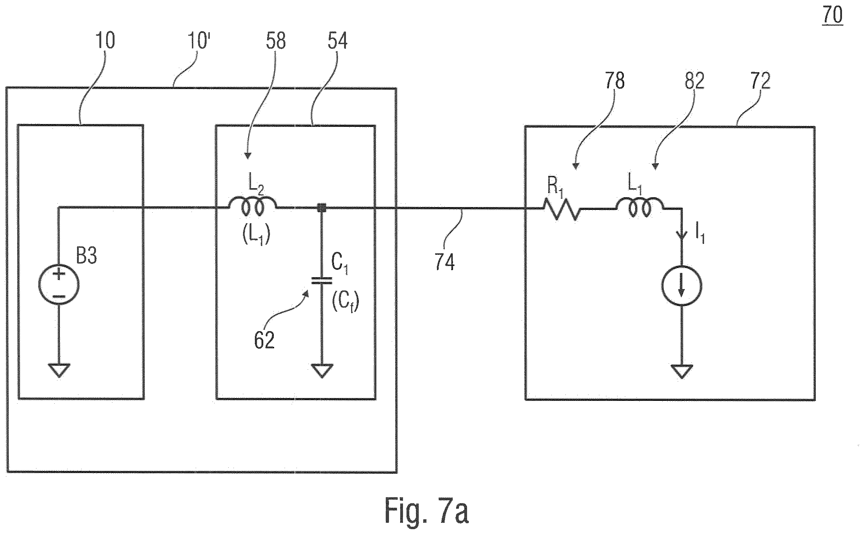

Fig. 7a zeigt ein schematisches Blockschaltbild eines Systems 70, mit einem Umrichter 10', der beispielsweise den Umrichter 10, der als Halbbrücke ausgeführt ist, umfasst und der das Filter 54 umfasst. Das Filter 54 umfasst beispielsweise das induktive Element 58 und das kapazitive Elemente 62, die zu einem Tiefpassfilter verschaltet sind. Das Filter 54 kann auch als Doppelpulsfilter bezeichnet werden, da durch den impulsartigen Wechsel der Flanke 22 und den zuvor angeordneten Impuls 24 zwei Pulse auf das Filter wirken können. Zwischen dem Umrichter 10' und der elektrischen Last 72 ist ein Motorkabel 74 angeordnet und verbindet den Umrichter 10' mit der elektrischen Last 72 elektrisch. Ein Ersatzschaltbild der elektrischen Last 72 umfasst beispielsweise ein resistives Element 78 und ein induktives Element 82, die seriell hintereinander geschaltet sind, wobei ein Phasenstrom $I_1$ durch die elektrische Last 72 fließt. Die elektrische Last 72 ist als einphasiger Motor dargestellt, wobei die elektrische Last 72 eine beliebige andere Konfiguration aufweisen kann, wie vorangehend erläutert. In der dargestellten Konfiguration ist das Filter 54 örtlich benachbart zu dem Umrichter 10 angeordnet und zu dem Umrichter 10' zusammengefasst. Das bedeutet, dass das Filter 54 in der Nähe der Energieversorgung angeordnet sein kann und durch das Motorkabel 74 von der elektrischen Lasst 72 beabstandet sein kann. In anderen Worten kann das Filter 54 im Umrichter 10' realisiert werden.

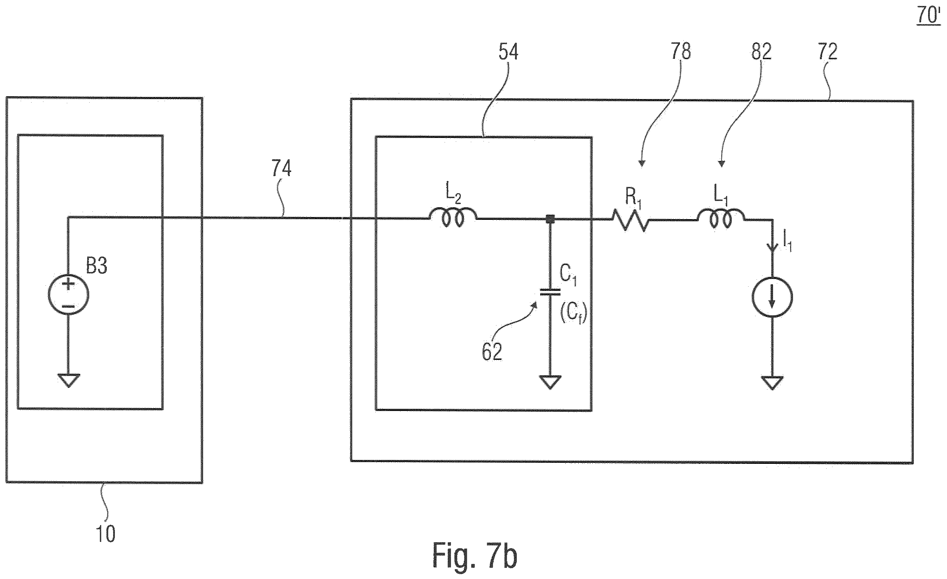

Fig. 7b zeigt ein schematisches Blockschaltbild eines Systems 70', bei dem die Verbindung 74, das heißt das Motorkabel ein induktives Element des Filters 54 bildet, das bedeutet die parasitäre Induktivität des Kabels 74 wird als Filterinduktivität genutzt. Zusätzlich kann das kapazitive Element 62 angeordnet sein, so dass das Filter 54 unter Ausnutzung der Induktivität des Kabels 74 sowie eines zusätzlichen Kondensators, das heißt dem kapazitiven Element 62 gebildet sein kann. Das kapazitive Element 62 kann örtlich benachbart zu oder in der elektrischen Last 72 angeordnet oder verbaut sein. Es wird deutlich, dass die elektrische Last 72 selbst ebenfalls elektrische Eigenschaften aufweisen kann, die den Gesamtschwingkreis beeinflussen. Das bedeutet, durch das Filter 54 und/oder durch das Kabel 74 kann der Schwingkreis der elektrischen Last 72 beeinflusst oder hergestellt werden.

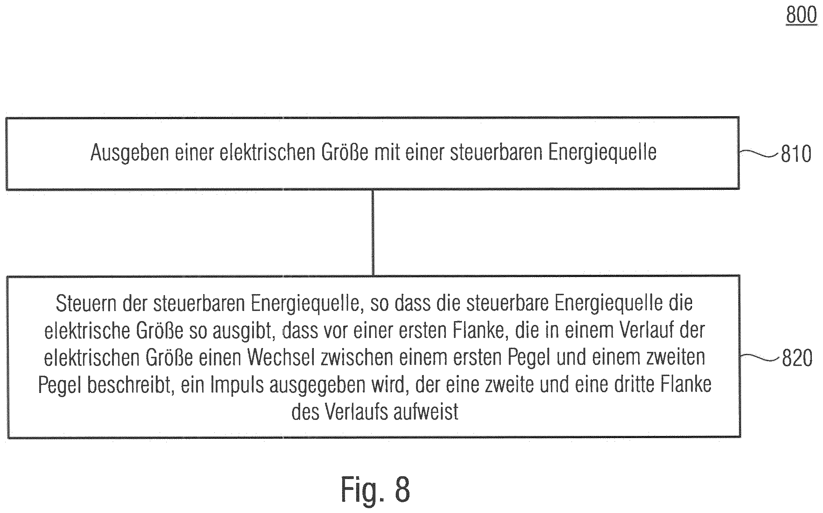

Fig. 8 zeigt ein schematisches Flussdiagramm eines Verfahrens 800 zur Steuern einer steuerbaren Energiequelle, das auch zum Steuern einer hierin beschriebenen Vorrichtung und/oder eines hierin beschriebenen Systems verwendet werden kann. Das Verfahren 800 umfasst einen Schritt 810, in welchem eine elektrische Größe mit einer steuerbaren Energiequelle ausgegeben wird. Ein Schritt 820 umfasst ein Steuern der steuerbaren Energiequelle, so dass die steuerbare Energiequelle die elektrische Größe so ausgibt, dass vor einer ersten Flanke, die in einem Verlauf der elektrischen Größe einen Wechsel zwischen einem ersten Pegel und einem zweiten Pegel beschreibt, ein Impuls ausgegeben wird, der eine zweite und eine dritte Flanke des Verlaufs aufweist.

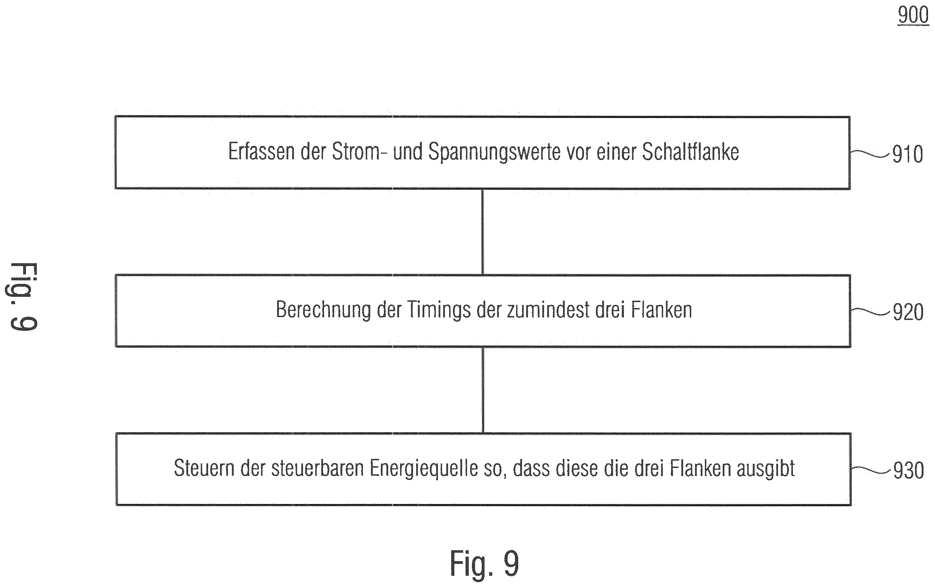

Fig. 9 zeigt ein schematisches Flussdiagramm eines Verfahrens 900 gemäß einem Ausführungsbeispiel. In einem Schritt 910 erfolgt ein Erfassen der Strom- und Spannungswerte vor einer Schaltflanke, etwa des PWM-Signals. In einem Schritt 920 erfolgt ein Berechnung der Timings der zumindest drei Flanken, d. h., der Flanken des zumindest einen Impulses bezüglich der Schaltflanke. Dies kann bspw. von der Steuereinheit 14 ausgeführt werden, die hierfür die hierin beschriebenen Auslegungsregeln anwenden kann. In einem Schritt 930 erfolgt ein Steuern der steuerbaren Energiequelle so, dass diese die drei Flanken ausgibt.

Das hierin beschriebene Doppelpulsfilter, das bedeutet die Ansteuerung der steuerbaren Energiequelle derart, dass vor einem PWM-Flankenwechsel ein oder mehrere zusätzliche Impulse ausgegeben werden, ermöglicht es, anstelle eines Sinusfilters am Modulausgang lediglich ein sehr kleines Filter mit einer wesentlich höheren Grenzfrequenz einzusetzen. Um das unkontrollierte Schwingen dieses Filters zu verhindern, kann Doppel- oder Mehrfachpuls genutzt werden, um das Filter gezielt anzutakten oder vorzuladen. Durch dieses doppelte oder mehrfache Antakten kann das Filter im Wesentlichen sofort oder nahezu zeitgleich in den stationären Zustand gebracht werden, wenn der PWM-Flankenwechsel angesteuert wird. Am Ausgang des Umrichters kann sich das typische Pulsmuster, etwa ein Spacevektormuster ergeben, das jedoch eine drastisch reduzierte Flankensteilheit aufweist. Diese Flankensteilheit kann dem verwendeten Filter entsprechen.

Das Filter und/oder das verwendete Verfahren, das heißt die Filtermethode, kann auf rein passiven oder reaktiven Komponenten basieren, das heißt das System kann mit Ausnahme von parasitären Verlusten verlustfrei arbeiten. Das Filter kann so gebildet sein, dass es zusätzliche oder weitere resistive Elemente aufweist, um zusätzliche Schwingungen zu unterdrücken, dies ist jedoch nicht zwingend erforderlich. Die Doppel- oder Mehrfachpulse, das heißt das Anordnen zumindest eines zusätzlichen Impulses kann bei jedem Flankenwechsel erfolgen, um das Filter bei jedem Flankenwechsel in den stationären Zustand zu bringen, wobei die Spannungssteilheit am Ausgang des Filters verlustarm oder annahmeweise verlustfrei reduziert werden kann. Anstelle des stationären Zustands kann auch ein Umladen der passiven Bauelemente, etwa von Kondensatoren oder Spulen auf gewünschte Werte erfolgen. Weist das Filter ein induktives Element auf, das heißt eine Speicherdrossel oder wird diese durch eine parasitäre Induktivität realisiert, so kann dies durch relativ klein dimensionierte Elemente erfolgen, da die Speicherdrossel lediglich sehr kurze Pulse energetisch aufnehmen und/oder abzugeben hat. Der Energiegehalt kann daher wesentlich kleiner sein als bei einem Sinusfilter. Eine Anforderung an die genutzte Induktivität besteht darin, lediglich zwei oder mehr Pulse pro Taktperiode aufzunehmen. Dies ermöglicht eine Ausgestaltung derart, dass magnetische Hystereseverluste relativ hoch sein können. Jedoch kann es vorteilhaft sein, die verwendete Induktivität so auszugestalten, dass sie den Nennstrom für die anzuschließende elektrische Last führen kann, wobei hier ebenfalls vorteilhaft ist, die Gleichspannungsverluste der Induktivität niedrig auszulegen. Das Filter kann alternativ oder zusätzlich ein kapazitives Element (Kondensator) aufweisen. In einem derartigen Fall kann der Kondensator für den Flankenwechselpuls sowie den zumindest einen zusätzlichen Puls ausgelegt sein, um während einer Taktperiode mittels der zumindest zwei Pulse umgeladen zu werden. Der Kondensator wird somit nur kurz belastet und zeigt somit ggf. eine geringe mittlere (Root-Mean-Square; RMS) Belastung. Die Anforderung an den Kondensator ist somit geringer, da er sehr viel weniger Energie zu speichern hat als ein Kondensator eines Sinusfilters, beispielsweise weniger als 5 %, weniger als 3 % oder weniger als 1 % der Energie. Er ist somit wesentlich kleiner auslegbar als der Kondensator eines Sinusfilters.

Die hierin beschriebenen Ausführungsbeispiele können für oder zusammen mit Umrichter für Elektromotoren, beispielsweise in Industrieanwendungen oder im Rahmen der Elektromobilität eingesetzt werden. Alternativ oder zusätzlich können Ausführungsbeispiele im Rahmen von intelligenten, adaptiven Leistungsendstufen, etwa für die Industrie 4.0 eingesetzt werden. Ein diskret realisiertes Filter kann zusammen mit der ansteuerbaren Energiequelle und/oder der Steuereinheit realisiert sein, das heißt das Filter kann zusammen im Ansteuermodul realisiert sein. Es kann ein Einbau diskreter Elemente, etwa eines einzelnen Ls, eines einzelnen Cs, etwa unter Verwendung eines Folienkondensators und/oder eines Keramikkondensators erfolgen. Der Kondensator kann als Silizium-Kondensator oder als Silizium-Snubber realisiert sein. Alternativ oder zusätzlich können parasitäre Elemente ausgenutzt werden, etwa Widerstände, Induktivitäten oder Kapazitäten. Beispielsweise kann ein Modul- oder Zuleitungsinduktivität genutzt werden. Die hierin beschriebenen Ausführungsbeispiele ermöglichen den Einsatz von integrierten Bauteilen, etwa magnetische umspritzte Leiter, die anders als diskrete Bauteile ausgeführt sind. Alternativ zur Ausführung im Modul kann auch eine Implementierung als Hybridmodul genutzt werden, das bedeutet der Anschluss von externen Elementen, das bedeutet das Filter oder der Umrichter und/oder das System kann Anschlüsse aufweisen, um Filterelemente, etwa Induktivitäten, Kapazitäten oder resistive Elemente extern zu verbinden. Beispielsweise können zwei Anschlüsse für eine Induktivität vorgesehen sein. Alternativ oder zusätzlich ist die Ausführung des Filters derart möglich, dass Zuleitungsinduktivitäten und am Motor angeordnete Filter ausgenutzt werden. Alternativ oder zusätzlich kann dies auch mit Kondensatoren als Filter erfolgen, die am Motor angeordnet sind. Hier ist ermöglicht, dass die Zuleitung zum Motor als alleinige Induktivität genutzt wird. Ausführungsbeispiele umfassen Mittel und Verfahren zur Messung der Eigenfrequenz der Filterstruktur unabhängig von der Implementierung der Filterstruktur, so dass als mögliche Option eine adaptive Einstellung der Pulse bei variabler Konfiguration des Filters ermöglicht ist, insbesondere bei unterschiedlichen Kabellängen oder dergleichen. Die hierin beschriebenen Ausführungsbeispiele können auch in einem System oder einer Vorrichtung genutzt werden, die für Multilevelwandler genutzt wird, das bedeutet PWM-Signale mit mehr als zwei Spannungspegeln. Durch zusätzliches Pulsen, das heißt eine höhere Anzahl von Pulsen, kann ein weiteres Reduzieren der Steilheit der Schaltflanken erfolgen.

Obwohl manche Aspekte im Zusammenhang mit einer Vorrichtung beschrieben wurden, versteht es sich, dass diese Aspekte auch eine Beschreibung des entsprechenden Verfahrens darstellen, sodass ein Block oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar.

Je nach bestimmten Implementierungsanforderungen können Ausführungsbeispiele der Erfindung in Hardware oder in Software implementiert sein. Die Implementierung kann unter Verwendung eines digitalen Speichermediums, beispielsweise einer Floppy-Disk, einer DVD, einer Blu-ray Disc, einer CD, eines ROM, eines PROM, eines EPROM, eines EEPROM oder eines FLASH-Speichers, einer Festplatte oder eines anderen magnetischen oder optischen Speichers durchgeführt werden, auf dem elektronisch lesbare Steuersignale gespeichert sind, die mit einem programmierbaren Computersystem derart zusammenwirken können oder zusammenwirken, dass das jeweilige Verfahren durchgeführt wird. Deshalb kann das digitale Speichermedium computerlesbar sein. Manche Ausführungsbeispiele gemäß der Erfindung umfassen also einen Datenträger, der elektronisch lesbare Steuersignale aufweist, die in der Lage sind, mit einem programmierbaren Computersystem derart zusammenzuwirken, dass eines der hierin beschriebenen Verfahren durchgeführt wird.

Allgemein können Ausführungsbeispiele der vorliegenden Erfindung als Computerprogrammprodukt mit einem Programmcode implementiert sein, wobei der Programmcode dahin gehend wirksam ist, eines der Verfahren durchzuführen, wenn das Computerprogrammprodukt auf einem Computer abläuft. Der Programmcode kann beispielsweise auch auf einem maschinenlesbaren Träger gespeichert sein.

Andere Ausführungsbeispiele umfassen das Computerprogramm zum Durchführen eines der hierin beschriebenen Verfahren, wobei das Computerprogramm auf einem maschinenlesbaren Träger gespeichert ist.

Mit anderen Worten ist ein Ausführungsbeispiel des erfindungsgemäßen Verfahrens somit ein Computerprogramm, das einen Programmcode zum Durchführen eines der hierin beschriebenen Verfahren aufweist, wenn das Computerprogramm auf einem Computer abläuft. Ein weiteres Ausführungsbeispiel der erfindungsgemäßen Verfahren ist somit ein Datenträger (oder ein digitales Speichermedium oder ein computerlesbares Medium), auf dem das Computerprogramm zum Durchführen eines der hierin beschriebenen Verfahren aufgezeichnet ist.

Ein weiteres Ausführungsbeispiel des erfindungsgemäßen Verfahrens ist somit ein Datenstrom oder eine Sequenz von Signalen, der bzw. die das Computerprogramm zum Durchführen eines der hierin beschriebenen Verfahren darstellt bzw. darstellen. Der Datenstrom oder die Sequenz von Signalen kann bzw. können beispielsweise dahin gehend konfiguriert sein, über eine Datenkommunikationsverbindung, beispielsweise über das Internet, transferiert zu werden.

Ein weiteres Ausführungsbeispiel umfasst eine Verarbeitungseinrichtung, beispielsweise einen Computer oder ein programmierbares Logikbauelement, die dahin gehend konfiguriert oder angepasst ist, eines der hierin beschriebenen Verfahren durchzuführen.

Ein weiteres Ausführungsbeispiel umfasst einen Computer, auf dem das Computerprogramm zum Durchführen eines der hierin beschriebenen Verfahren installiert ist.

Bei manchen Ausführungsbeispielen kann ein programmierbares Logikbauelement (beispielsweise ein feldprogrammierbares Gatterarray, ein FPGA) dazu verwendet werden, manche oder alle Funktionalitäten der hierin beschriebenen Verfahren durchzuführen. Bei manchen Ausführungsbeispielen kann ein feldprogrammierbares Gatterarray mit einem Mikroprozessor zusammenwirken, um eines der hierin beschriebenen Verfahren durchzuführen. Allgemein werden die Verfahren bei einigen Ausführungsbeispielen seitens einer beliebigen Hardwarevorrichtung durchgeführt. Diese kann eine universell einsetzbare Hardware wie ein Computerprozessor (CPU) sein oder für das Verfahren spezifische Hardware, wie beispielsweise ein ASIC.

Die oben beschriebenen Ausführungsbeispiele stellen lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten einleuchten werden. Deshalb ist beabsichtigt, dass die Erfindung lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

**Patentansprüche**

1. Vorrichtung (20; 40) mit:

   einem Umrichter (10) mit:

   einer steuerbaren Energiequelle (12), die ausgebildet ist, um eine elektrische Größe (18) auszugeben; und
   einer Steuereinheit (14), die ausgebildet ist, um die steuerbare Energiequelle (12) zu steuern, so dass die steuerbare Energiequelle (12) die elektrische Größe (18) so ausgibt, dass vor einer ersten Flanke (22; 22a-b; 36a-b), die in einem Verlauf der elektrischen Größe (18) einen Wechsel zwischen einem ersten Pegel ($L_1$-$L_3$) und einem zweiten Pegel ($L_1$-$L_3$) beschreibt, ein Impuls (24; 24a-b; 38a-b) ausgeben wird, der eine zweite (26; 26a-b; 42a-b) und eine dritte Flanke (28; 28a-b; 44a-b) des Verlaufs aufweist;

   wobei die Vorrichtung ferner ein Filter (54) umfasst;
   wobei die Steuereinheit (14) ausgebildet ist, um die steuerbare Energiequelle (12) so zu steuern, dass der Impuls (24; 24a-b; 38a-b) einen zeitlichen Abstand (34) zu der ersten Flanke (22; 22a-b; 36a-b) aufweist, und dass eine Filterantwort (52a, 52b) des Filters (54) auf den Impuls (24; 24a-b; 38a-b) Schwingungen des Filters (54), die auf der ersten Flanke (22; 22a-b; 36a-b) beruhen, zumindest teilweise kompensiert;
   wobei die Steuereinheit (14) ausgebildet ist, um die Grenzfrequenz des Filters (54) zu bestimmen, und um den zeitlichen Abstand (34) zwischen dem Impuls (24; 24a-b; 38a-b) und der ersten Flanke (22; 22a-b; 36a-b) und/oder eine Zeitdauer (32) des Impulses (24; 24a-b; 38a-b) basierend auf der bestimmten Grenzfrequenz einzustellen.

2. Vorrichtung gemäß Anspruch 1, bei dem die Steuereinheit (14) ausgebildet ist, um die steuerbare Energiequelle (12) so zu steuern, dass diese mit einem eine Taktperiodendauer ($T_p$) aufweisenden Takt wiederholende Wechsel zwischen dem ersten ($L_1$-$L_3$) und dem zweiten Pegel ($L_1$-$L_3$) ausgibt, und so dass diese den Impuls (24; 24a-b; 38a-b) mit einem zeitlichen Abstand (34) von der ersten Flanke (22; 22a-b; 36a-b) von höchstens 25 % der Taktperiodendauer ($T_p$) ausgibt und/oder wobei der der ersten Flanke (22; 22a-b; 36a-b) vorangehende Impuls (24) eine Dauer (32) aufweist, die höchstens 25 % der Taktperiodendauer ($T_p$) beträgt.

3. Vorrichtung gemäß Anspruch 1 oder 2, bei dem die Steuereinheit (14) ausgebildet ist, um die steuerbare Energiequelle (12) so zu steuern, dass eine zeitliche Dauer (32) des Impulses (24; 24a-b; 38a-b) mit einer Toleranz von $\pm$20 % gleich dem zeitlichen Abstand (34) zwischen dem Impuls (24; 24a-b; 38a-b) und der ersten Flanke (22; 22a-b; 36a-b) ist.

4. Vorrichtung gemäß einem der vorangehenden Ansprüche, bei dem der Impuls ein erster Impuls (24a) ist, und bei dem die Steuereinheit (14) ausgebildet ist, um die steuerbare Energiequelle (12) so zu steuern dass diese die elektrische Größe (18) so ausgibt, dass vor einer vierten Flanke, die in dem Verlauf der elektrischen Größe einen Wechsel zwischen dem zweiten Pegel ($L_2$) und einem dritten Pegel ($L_3$) beschreibt, ein zweiter Impuls (38b) ausgeben wird, der eine fünfte und eine sechste Flanke des Verlaufs aufweist, wobei der dritte Pegel ($L_3$) größer oder kleiner ist als der zweite Pegel ($L_2$) und größer oder kleiner ist als der erste Pegel ($L_1$) und wobei eine Amplitude des ersten Impulses (24a) dem zweiten Pegel ($L_2$) entspricht und eine Amplitude des zweiten Impulses (24b) dem dritten Pegel ($L_3$) entspricht.

**5.** Vorrichtung gemäß einem der vorangehenden Ansprüche, wobei die Steuereinheit (14) ausgebildet ist, um die steuerbare Energiequelle (12) so zu steuern, dass diese mit einem eine Taktperiodendauer ($T_p$) aufweisenden Takt wiederholende Wechsel zwischen dem ersten ($L_1$-$L_3$) und dem zweiten Pegel ($L_1$-$L_3$) ausgibt, und so dass der ersten Flanke (22; 22a-b; 36a-b) eine Folge von zumindest zwei Impulsen (24a, 24c; 24b, 24d; 38a, 38c; 38b, 38d) vorausgeht, wobei eine zeitliche Dauer der Folge der zumindest zwei Impulsen (24a, 24c; 24b, 24d; 38a, 38c; 38b, 38d) höchstens 25 % der Taktperiodendauer ($T_p$) beträgt.

**6.** Vorrichtung gemäß einem der vorangehenden Ansprüche, der ausgebildet ist, um zumindest einen der ersten Flanke (22; 22a-b; 36a-b) vorausgehenden Impuls (24; 24a-b; 38a-b) so zu erzeugen, dass eine Filterantwort (52a, 52b) auf die erste Flanke (22; 22a-b; 36a-b) und auf den Impuls (24; 24a-b; 38a-b) sich so überlagern, dass Schwingungen in der Filterantwort (52c) zumindest teilweise kompensiert werden.

**7.** Vorrichtung gemäß einem der vorangehenden Ansprüche, bei der das Filter (54) ein Tiefpass umfassend ein induktives Element (58; $L_p$) und eine kapazitives Element (62; $C_p$) ist.

**8.** Vorrichtung gemäß einem der vorangehenden Ansprüche, bei der die Steuereinheit (14) ausgebildet ist, um die steuerbare Energiequelle (12) so zu steuern, dass eine zeitliche Dauer (22) des Impulses innerhalb eines Toleranzbereichs von $\pm$ 50 % dem Kehrwert einer sechsfachen Resonanzfrequenz des Filters (54) entspricht.

**9.** Vorrichtung gemäß einem der vorangehenden Ansprüche, bei der die Steuereinheit (14) ausgebildet ist, um die steuerbare Energiequelle (12) so zu steuern, dass ein durch ein induktives Element (58) des Filters (54) fließender Strom zu einem Beginn des Impulses (24; 24a-b; 38a-b) mit einer Toleranz von $\pm$5 % gleich einem durch das induktive Element (58; $L_p$) des Filters fließendem Strom zum Zeitpunkt der ersten Flanke (22; 22a-b; 36a-b) ist.

**10.** Vorrichtung gemäß einem der vorangehenden Ansprüche, bei dem das Filter (54) ausgebildet ist, um basierend auf der elektrischen Größe (18) eine gefilterte elektrische Größe (64) auszugeben, die bei einem Wechsel von dem ersten Pegel ($L_1$-$L_3$) in den zweiten Pegel ($L_1$-$L_3$) eine Flanke mit einer zeitlichen Dauer ($t_3$-$t_1$) aufweist, wobei die Steuereinheit (14) ausgebildet ist, um die steuerbare Energiequelle (12) so zu steuern, dass eine Zeitdauer ($t_3$-$t_1$) des zumindest einen Impulses (24; 24a-b; 38a-b) mit einer Toleranz von $\pm$10 % der Hälfte der zeitlichen Dauer der Flanke aufweist.

**11.** System (60; 70; 70') mit:

einer Vorrichtung (20; 40) nach einem der Ansprüche 1 bis 10;
einer elektrischen Last (72), die mit einem Ausgang des Filters (54) verbunden ist und zumindest einen Teil eines Resonanzschwingkreises mit dem Filter (54) bildet;
wobei der Umrichter (10; 10') der Vorrichtung ausgebildet ist, um die Last (72) mit einem pulsweitenmodulierten Signal, das eine Taktfrequenz ($1/T_p$) aufweist, anzusteuern;
wobei eine Grenzfrequenz des Resonanzschwingkreises höher ist, als die Taktfrequenz ($1/T_p$).

**12.** System gemäß Anspruch 11, bei dem das Filter (54) benachbart zu der elektrischen Last (72) und beabstandet von der Steuereinheit (14) angeordnet ist.

**13.** System gemäß Anspruch 11 oder 12, bei dem das Filter (54) ein LC-Filter ist und ein induktives Element (58) aufweist, das durch ein Kabel (74) zwischen dem Filter (54) und der elektrischen Last (72) realisiert ist.

**14.** System gemäß einem der Ansprüche 11 bis 13, bei dem das Filter (54) ausgebildet ist, um basierend auf der elektrischen Größe (18) eine gefilterte elektrische Größe (64) auszugeben, die bei einem Wechsel von dem ersten Pegel ($L_1$-$L_3$) in den zweiten Pegel ($L_1$-$L_3$) eine Flanke mit einer Flankensteilheit aufweist, und bei dem ein Kapazitätswert eines kapazitiven Elements (62; $C_p$) des Filters so gewählt ist, dass basierend auf einem Induktivitätswert eines induktiven Elements (58; $L_p$) des Filters (54) eine Flankensteilheit der gefilterten elektrischen Größe (64) von höchstens 10 kV/$\mu$s erhalten wird.

**15.** System gemäß einem der Ansprüche 11 bis 13, bei dem die Grenzfrequenz von einem parasitärem Kapazitätswert ($C_p$) der elektrischen Last (72) oder einer Verbindung (74) derselben mit der steuerbaren Energiequelle (12) bestimmt ist.

**16.** System gemäß Anspruch 15, bei dem, bei dem die Grenzfrequenz von der Verbindung (74) zwischen der elektrischen Last (72) und der steuerbaren Energiequelle (12) bestimmt ist, wobei die Verbindung (74) einen parasitären Induktivitätswert ($L_p$) und einen parasitären Kapazitätswert ($C_p$) aufweist, wobei die Steuereinheit (14) ausgebildet ist, um die steuerbare Energiequelle (12) so zu steuern, dass ein erhaltener parasitärer Schwingkreis (76) basierend auf dem Impuls (24; 24a-b; 38a-b) so angeregt wird, dass der parasitäre Schwingkreis (76) vor dem Impuls (24; 24a-b; 38a-b) und nach der ersten Flanke (22; 22a-b; 36a-b) in einem stationären Zustand ist.

17. Verfahren (800) mit folgenden Schritten:

Ausgeben (810) einer elektrischen Größe (18) mit einer steuerbaren Energiequelle (12);
Steuern (820) der steuerbaren Energiequelle (12), so dass die steuerbare Energiequelle (12) die elektrische Größe (18) so ausgibt, dass vor einer ersten Flanke (22; 22a-b; 36a-b), die in einem Verlauf der elektrischen Größe (18) einen Wechsel zwischen einem ersten Pegel ($L_1$-$L_3$) und einem zweiten Pegel ($L_1$-$L_3$) beschreibt, ein Impuls (24; 24a-b; 38a-b) ausgeben wird, der eine zweite (26; 26a-b; 42a-b) und eine dritte Flanke (28; 28a-b; 44a-b) des Verlaufs aufweist; und so, dass der Impuls (24; 24a-b; 38a-b) einen zeitlichen Abstand (34) zu der ersten Flanke (22; 22a-b; 36a-b) aufweist, und dass eine Filterantwort (52a, 52b) eines Filters (54) auf den Impuls (24; 24a-b; 38a-b) Schwingungen des Filters (54), die auf der ersten Flanke (22; 22a-b; 36a-b) beruhen, zumindest teilweise kompensiert;
Bestimmen der Grenzfrequenz des Filters (54), und Einstellen des zeitlichen Abstandes (34) zwischen dem Impuls (24; 24a-b; 38a-b) und der ersten Flanke (22; 22a-b; 36a-b) und/oder einer Zeitdauer (32) des Impulses (24; 24a-b; 38a-b) basierend auf der bestimmten Grenzfrequenz.

**Claims**

1. Apparatus (20; 40) comprising:

an inverter (10) comprising:

a controllable energy source (12) configured to output an electric quantity (18); and
a control unit (14) configured to control the controllable energy source (12) such that the controllable energy source (12) outputs the electric quantity (18) such that, before a first slope (22; 22a-b; 36a-b) describing a change between a first level ($L_1$-$L_3$) and a second level ($L_1$-$L_3$) in a progression of the electric quantity (18), an impulse (24; 24a-b; 38a-b) comprising a second (26; 26a-b; 42a-b) and a third slope (28; 28a-b; 44a-b) of the progression is output;

wherein the apparatus further includes a filter (54);
wherein the control unit (14) is configured to control the controllable energy source (12) such that the impulse (24; 24a-b; 38a-b) comprises a temporal distance (34) to the first slope (22; 22a-b;

36a-b) and such that a filter response (52a, 52b) of the filter (54) to the impulse (24; 24a-b; 38a-b) at least partially compensates oscillations of the filter (54) which are based on the first slope (22; 22a-b; 36a-b);
wherein the control unit (14) is configured to determine the threshold frequency of the filter (54) and to set the temporal distance (34) between the impulse (24; 24a-b; 38a-b) and the first slope (22; 22a-b; 36a-b) and/or a temporal duration (32) of the impulse (24; 24a-b; 38a-b) based on the determined threshold frequency.

2. Apparatus according to claim 1, wherein the control unit (14) is configured to control the controllable energy source (12) such that it outputs repeating changes between the first ($L_1$-$L_3$) and the second level ($L_1$-$L_3$) with a clock comprising a clock period duration ($T_P$), and such that it outputs the impulse (24; 24a-b; 38a-b) with a temporal distance (34) to the first slope (22; 22a-b; 36a-b) of up to 25% of the clock period duration ($T_P$) and/or wherein the impulse (24) preceding the first slope (22; 22a-b; 36a-b) comprises a duration (32) that is at most 25% of the clock period duration ($T_P$).

3. Apparatus according to claim 1 or 2, wherein the control unit (14) is configured to control the controllable energy source (12) such that a temporal duration (32) of the impulse (24; 24a-b; 38a-b) is equal to the temporal distance (34) between the impulse (24; 24a-b; 38a-b) and the first slope (22; 22a-b; 36a-b) with a tolerance of $\pm 20$ %.

4. Apparatus according to any one of the preceding claims, wherein the impulse is a first impulse (24a), and wherein the control unit (14) is configured to control the controllable energy source (12) such that it outputs the electric quantity (18) so that, before a forth slope describing a change between the second level ($L_2$) and the third level ($L_3$) in the progression of the electric quantity, a second impulse (38b) comprising a fifth and a sixth slope of the progression is output, wherein the third level ($L_3$) is larger or smaller than the second level ($L_2$) and larger or smaller than the first level ($L_1$), and wherein an amplitude of the first impulse (24a) corresponds to the second level ($L_2$) and an amplitude of the second impulse (24b) corresponds to the third level ($L_3$).

5. Apparatus according to any one of the preceding claims, wherein the control unit (14) is configured to control the controllable energy source (12) such that it outputs repeating changes between the first ($L_1$-$L_3$) and the second level ($L_1$-$L_3$) with a clock comprising a clock period duration ($T_P$), and such that the first slope (22; 22a-b; 36a-b) is preceded by a sequence of at least two impulses (24a, 24c; 24b, 24d; 38a, 38c; 38b, 38d), wherein a duration of the sequence of the at least two impulses (24a, 24c; 24b, 24d; 38a, 38c; 38b, 38d) is at most 25 % of the clock period duration ($T_P$).

6. Apparatus according to any one of the preceding claims, configured to generate at least one impulse (24; 24a-b; 38a-b) preceding the first slope (22; 22a-b; 36a-b) such that a filter response (52a, 52b) to the first slope (22; 22a-b; 36a-b) and to the impulse (24; 24a-b; 38a-b) overlap in such a way that oscillations in the filter response (52c) are at least partially compensated.

7. Apparatus according to any one of the preceding claims, wherein the filter (54) is a low pass including an inductive element (58; $L_p$) and a capacitive element (62; $C_p$).

8. Apparatus according to any one of the preceding claims, wherein the control unit (14) is configured to control the controllable energy source (12) such that a temporal duration (22) of the impulse corresponds to the reciprocal of six times the resonant frequency of the filter (54) within a tolerance range ±50 %.

9. Apparatus according to any one of the preceding claims, wherein the control unit (14) is configured to control the controllable energy source (12) such that a current flowing through an inductive element (58) of the filter (54) at the beginning of the impulse (24; 24a-b; 38a-b) is equal to a current flowing through the inductive element (58, $L_p$) of the filter at the point in time of the first slope (22; 22a-b; 36a-b) with a tolerance of ± 5%.

10. Apparatus according to any one of the preceding claims, wherein the filter (54) is configured to, based on the electric quantity (18), output a filtered electric quantity (64) comprising, when changing from the first level ($L_1$-$L_3$) to the second level ($L_1$-$L_3$), a slope with a temporal duration ($t_3$-$t_1$), wherein the control unit (14) is configured to control the controllable energy source (12) such that a duration ($t_3$-$t_1$) of the at least one impulse (24; 24a-b; 38a-b) comprises half of the duration of a slope with a tolerance of ±10%.

11. System (60; 70; 70') comprising:

an apparatus (20; 40) according to any one of claims 1 to 10;
an electric load (72) connected to an output of the filter (54) and forming at least a part of a resonance circuit with the filter (54);
wherein the inverter (10; 10') of the apparatus is configured to drive the load (72) with a pulse-width modulated signal comprising a clock frequency (1/$T_P$);

wherein a threshold frequency of the resonance circuit is larger than the clock frequency (1/$T_p$).

12. System according to claim 11, wherein the filter (54) is arranged adjacent to the electric load (72) and spaced apart from the control unit (14).

13. System according to claim 11 or 12, wherein the filter (54) is an LC filter and comprises an inductive element (58) realized by a cable (74) between the filter (54) and the electric load (72).

14. System according to any one of claims 11 to 13, wherein the filter (54) is configured to, based on the electric quantity (18), output a filtered electric quantity (64) which, when changing from the first level ($L_1$-$L_3$) into the second level ($L_1$-$L_3$), comprises a slope with a slope steepness, and wherein a capacitance value of a capacitive element (62; $C_p$) of the filter is selected such that, based on an inductance value of an inductive element (58; $L_p$) of the filter (54), a slope steepness of the filtered electric quantity (64) of at most 10kV/µs is obtained.

15. System according to any one of claims 11 to 13, wherein the threshold frequency is determined by a parasitic capacitance value ($C_p$) of the electric load (72) or a connection (74) of the same to the controllable energy source (12).

16. System according to claim 15, wherein the threshold frequency is determined by the connection (74) between the electric load (72) and the controllable energy source (12), wherein the connection (74) comprises a parasitic inductance value ($L_p$) and a parasitic capacitance value ($C_p$), wherein the control unit (14) is configured to control the controllable energy source (12) such that an obtained parasitic resonant circuit (76) is excited based on the impulse (24; 24a-b; 38a-b) such that the parasitic resonant circuit (76) is in an stationary state before the impulse (24; 24a-b; 38a-b) and after the first slope (22; 22a-b; 36a-b).

17. Method (800) comprising:

outputting (810) an electric quantity (18) with a controllable energy source (12);
controlling (820) the controllable energy source (12) such that the controllable energy source (12) outputs the electric quantity (18) such that, before a first slope (22; 22a-b; 36a-b) describing a change between a first level ($L_1$-$L_3$) and a second level ($L_1$-$L_3$) in a progression of the electric quantity (18), an impulse (24; 24a-b; 38a-b) comprising a second (26; 26a-b; 42a-b) and a third slope (28; 28a-b; 44a-b) of the progression is output; and such that the impulse (24; 24a-b; 38a-b) comprises a temporal distance (34) to the first slope (22; 22a-b; 36a-b), and such that a filter response (52a, 52b) of a filter (54) to the impulse (24; 24a-b; 38a-b) at least partially compensates oscillations of the filter (54) that are based on the first slope (22; 22a-b; 36a-b); determining the threshold frequency of the filter (54), and

setting the temporal distance (34) between the impulse (24; 24a-b; 38a-b) and the first slope (22; 22a-b; 36a-b) and/or a duration (32) of the impulse (24; 24a-b; 38a-b) based on the determined threshold frequency.

## Revendications

1. Dispositif (20; 40), avec:

   un onduleur (10), avec:

   une source d'énergie pouvant être commandée (12) qui est conçue pour sortir une grandeur électrique (18); et une unité de commande (14) qui est conçue pour commander la source d'énergie pouvant être commandée (12) de sorte que la source d'énergie pouvant être commandée (12) sorte la grandeur électrique (18) de sorte que, avant un premier flanc (22; 22a à b; 36a à b) qui décrit, au cours d'une évolution de la grandeur électrique (18), un passage entre un premier niveau ($L_1$ à $L_3$) et un deuxième niveau (Li à $L_3$), soit sortie une impulsion (24; 24a à b; 38a à b) qui présente un deuxième (26; 26a à b; 42a à b) et un troisième flanc (28; 28a à b; 44a à b) de l'évolution;

   dans lequel le dispositif comporte par ailleurs un filtre (54); dans lequel l'unité de commande (14) est conçue pour commander la source d'énergie pouvant être commandée (12) de sorte que l'impulsion (24; 24a à b; 38a à b) présente une distance dans le temps (34) par rapport au premier flanc (22; 22a à b 36a à b), et qu'une réponse (52a, 52b) du filtre (54) à l'impulsion (24; 24a à b; 38a à b) compense au moins partiellement les oscillations du filtre (54) basées sur le premier flanc (22; 22a à b; 36a à b); dans lequel l'unité de commande (14) est conçue pour déterminer la fréquence de coupure du filtre (54), et pour régler la distance dans le temps (34) entre l'impulsion (24; 24a à b; 38a à b) et le premier flanc (22; 22a à b; 36a à b) et/ou une durée (32) de l'impulsion (24; 24a à b; 38a à b) sur base de la fréquence de coupure déterminée.

2. Dispositif selon la revendication 1, dans lequel l'unité de commande (14) est conçue pour commander la source d'énergie pouvant être commandée (12) de sorte qu'elle sorte avec une horloge présentant une durée de période d'horloge ($T_p$) les changements se répétant entre le premier ($L_1$ à $L_3$) et le deuxième niveau (Li à $L_3$), et de sorte qu'elle sorte l'impulsion (24; 24a à b; 38a à b) à une distance dans le temps (34) du premier flanc (22; 22a à b; 36a à b) de tout au plus 25% de la durée d'une période d'horloge ($T_p$) et/ou dans lequel l'impulsion (24) précédant le premier flanc (22; 22a à b; 36a à b) présente une durée (32) qui est de tout au plus 25% de la durée d'une période d'horloge ($T_p$).

3. Dispositif selon la revendication 1 ou 2, dans lequel l'unité de commande (14) est conçue pour commander la source d'énergie pouvant être commandée (12) de sorte qu'une durée dans le temps (32) de l'impulsion (24; 24a à b; 38a à b) soit, avec une tolérance de $\pm$ 20%, égale à la distance dans le temps (34) entre l'impulsion (24; 24a à b; 38a à b) et le premier flanc (22; 22a à b; 36a à b).

4. Dispositif selon l'une des revendications précédentes, dans lequel l'impulsion est une première impulsion (24a), et dans lequel l'unité de commande (14) est conçue pour commander la source d'énergie pouvant être commandée (12) de sorte qu'elle sorte la grandeur électrique (18) de sorte que, avant un quatrième flanc qui, au cours de l'évolution de la grandeur électrique, décrit un passage entre le deuxième niveau ($L_2$) et un troisième niveau ($L_3$), soit sortie une deuxième impulsion (38b) qui présente un cinquième et un sixième flanc de l'évolution, où le troisième niveau ($L_3$) est supérieur ou inférieur au deuxième niveau ($L_2$) et est supérieur ou inférieur au premier niveau ($L_1$) et dans lequel une amplitude de la première impulsion (24a) correspond au deuxième niveau ($L_2$) et une amplitude de la deuxième impulsion (24b) correspond au troisième niveau ($L_3$).

5. Dispositif selon l'une des revendications précédentes, dans lequel l'unité de commande (14) est conçue pour commander la source d'énergie pouvant être commandée (12) de sorte qu'elle sorte avec l'horloge présentant une durée d'une période d'horloge ($T_p$) les passages se répétant entre le premier ($L_1$ à $L_3$) et le deuxième niveau ($L_1$ à $L_3$), et de sorte que le premier flanc (22; 22a à b; 36a à b) précède une séquence d'au moins deux impulsions (24a, 24c; 24b, 24d; 38a, 38c; 38b, 38d), dans lequel une durée dans le temps de la séquence d'au moins deux impulsions (24a, 24c; 24b, 24d; 38a, 38c; 38b, 38d) est de tout au plus 25% de la durée d'une période d'horloge ($T_p$).

**6.** Dispositif selon l'une des revendications précédentes, qui est conçu pour générer au moins une impulsion (24; 24a à b; 38a à b) précédant le premier flanc (22; 22a à b; 36a à b) de sorte qu'une réponse de filtre (52a, 52b) au premier flanc (22; 22a à b; 36a à b) et à l'impulsion (24; 24a à b; 38a à b) se chevauchent de sorte que les vibrations dans la réponse de filtre (52c) soient au moins partiellement compensées.

**7.** Dispositif selon l'une des revendications précédentes, dans lequel le filtre (54) est un filtre passe-bas comportant un élément inductif (58; $L_p$) et un élément capacitif (62; $C_p$).

**8.** Dispositif selon l'une des revendications précédentes, dans lequel l'unité de commande (14) est conçue pour commander la source d'énergie pouvant être commandée (12) de sorte qu'une durée dans le temps (22) de l'impulsion corresponde, dans une plage de tolérances de $\pm$ 50%, à la valeur inverse d'une fréquence de résonance du filtre (54) multipliée par six.

**9.** Dispositif selon l'une des revendications précédentes, dans lequel l'unité de commande (14) est conçue pour commander la source d'énergie pouvant être commandée (12) de sorte qu'un courant circulant à travers un élément inductif (58) du filtre (54) soit, à un début de l'impulsion (24; 24a à b; 38a à b), avec une tolérance de $\pm$ 5%, égal à un courant circulant à travers l'élément inductif (58; $L_p$) du filtre au moment du premier flanc (22; 22a à b; 36a à b).

**10.** Dispositif selon l'une des revendications précédentes, dans lequel le filtre (54) est conçu pour sortir, sur base de la grandeur électrique (18), une grandeur électrique filtrée (64) qui présente, lors d'un passage du premier niveau ($L_1$ à $L_3$) au deuxième niveau (Li à $L_3$), un flanc avec une durée dans le temps (ti à t3), dans lequel l'unité de commande (14) est conçue pour commander la source d'énergie pouvant être commandée (12) de sorte qu'une durée dans le temps ($t_1$ à $t_3$) de l'au moins une impulsion (24; 24a à b; 38a à b) présente, avec une tolérance de $\pm$ 10%, la moitié de la durée dans le temps du flanc.

**11.** Système (60; 70; 70') avec:

un dispositif (20; 40) selon l'une des revendications 1 à 10;
une charge électrique (72) qui est connectée à une sortie du filtre (54) et constitue au moins une partie d'un circuit résonant avec le filtre (54);
dans lequel l'onduleur (10; 10') du dispositif est conçu pour activer la charge (72) par un signal modulé en largeur d'impulsion qui présente une fréquence d'horloge ($1/T_p$);
dans lequel une fréquence de coupure du circuit résonant est supérieure à la fréquence d'horloge ($1/T_p$).

**12.** Système selon la revendication 11, dans lequel le filtre (54) est disposé à proximité de la charge électrique (72) et distant de l'unité de commande (14).

**13.** Système selon la revendication 11 ou 12, dans lequel le filtre (54) est un filtre LC et présente un élément inductif (58) qui est réalisé par un câble (74) entre le filtre (54) et la charge électrique (72).

**14.** Système selon l'une des revendications 11 à 13, dans lequel le filtre (54) est conçu pour sortir, sur base de la grandeur électrique (18), une grandeur électrique filtrée (64) qui présente, lors d'un passage du premier niveau ($L_1$ à $L_3$) au deuxième niveau ($L_1$ à $L_3$), un flanc avec une pente de flanc, et dans lequel une valeur de capacité d'un élément capacitif (62; $C_p$) du filtre est choisie de sorte que sur base d'une valeur d'inductance d'un élément inductif (58; $L_p$) du filtre (54) soit obtenue une pente de flanc de la grandeur électrique filtrée (64) de tout au plus 10 kV/$\mu$s.

**15.** Système selon l'une des revendications 11 à 13, dans lequel la fréquence de coupure est déterminée par une valeur de capacité parasite ($C_p$) de la charge électrique (72) ou par une connexion (74) de cette dernière à la source d'alimentation pouvant être commandée (12).

**16.** Système selon la revendication 15, dans lequel la fréquence de coupure est déterminée par la connexion (74) entre la charge électrique (72) et la source d'énergie pouvant être commandée (12), dans lequel la connexion (74) présente une valeur d'inductance parasite ($L_p$) et une valeur de capacité parasite ($C_p$), dans lequel l'unité de commande (14) est conçue pour commander la source d'énergie pouvant être commandée (12) de sorte qu'un circuit résonnant parasite obtenu (76) soit excité sur base de l'impulsion (24; 24a à b; 38a à b) de sorte que le circuit résonnant parasite (76) se trouve, avant l'impulsion (24; 24a à b; 38a à b) et après le premier flanc (22; 22a à b; 36a à b), dans un état stationnaire.

**17.** Procédé (800) aux étapes suivantes consistant à:

sortir (810) une grandeur électrique (18) par une source d'énergie pouvant être commandée (12);
commander (820) la source d'énergie pouvant être commandée (12) de sorte que la source d'énergie pouvant être commandée (12) sorte la grandeur électrique (18) de sorte que, avant un premier flanc (22; 22a à b; 36a à b) qui décrit, au cours de l'évolution de la grandeur électrique (18), un passage entre un premier niveau ($L_1$ à $L_3$) et un deuxième niveau ($L_1$ à $L_3$), soit sortie une impulsion (24; 24a à b; 38a à b) qui présente un deuxième (26; 26a à b; 42a à b) et un troisième flanc (28; 28a-b; 44a à b) de l'évolution; et de sorte que l'impulsion (24; 24a à b; 38a à b) présente une distance dans le temps (34) par rapport au premier flanc (22; 22a à b; 36a à b) et qu'une réponse de filtre (52a, 52b) d'un filtre (54) à l'impulsion (24; 24a à b; 38a à b) compense au moins partiellement les vibrations du filtre (54) qui sont basées sur le premier flanc (22; 22a à b; 36a à b);

déterminer la fréquence de coupure du filtre (54), et régler la distance dans le temps (34) entre l'impulsion (24; 24a à b; 38a à b) et le premier flanc (22; 22a à b; 36a à b) et/ou une durée (32) de l'impulsion (24; 24a à b; 38a à b) sur base de la fréquence de coupure déterminée.

Fig. 1a

EP 3 410 589 B1

Fig. 1b

EP 3 410 589 B1

Fig. 1c

Fig. 1d

Fig. 1e

Fig. 1f

Fig. 2

EP 3 410 589 B1

Fig. 3

Fig. 4

EP 3 410 589 B1

Fig. 5

EP 3 410 589 B1

Fig. 6

EP 3 410 589 B1

Fig. 7a

EP 3 410 589 B1

Fig. 7b

Ausgeben einer elektrischen Größe mit einer steuerbaren Energiequelle — 810

Steuern der steuerbaren Energiequelle, so dass die steuerbare Energiequelle die elektrische Größe so ausgibt, dass vor einer ersten Flanke, die in einem Verlauf der elektrischen Größe einen Wechsel zwischen einem ersten Pegel und einem zweiten Pegel beschreibt, ein Impuls ausgegeben wird, der eine zweite und eine dritte Flanke des Verlaufs aufweist — 820

Fig. 8

EP 3 410 589 B1

900

910

Erfassen der Strom- und Spannungswerte vor einer Schaltflanke

920

Berechnung der Timings der zumindest drei Flanken

930

Steuern der steuerbaren Energiequelle so, dass diese die drei Flanken ausgibt

Fig. 9

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20080316780 A1

- JP H04340391 B